# EUROPEAN PATENT SPECIFICATION

(11) **EP 3 514 908 B1**
(45) Date of publication and mention of the grant of the patent: **09.02.2022**
(21) Application number: 18173698.4
(22) Date of filing: 22.05.2018
(51) Int. Cl.: H02J 3/00, H02J 3/38, H02J 13/00

(54) **METHODS AND DEVICES FOR CONDITION CLASSIFICATION OF POWER NETWORK ASSETS**
VERFAHREN UND VORRICHTUNGEN ZUR ZUSTANDSKLASSIFIZIERUNG VON STROMNETZANLAGEN
PROCÉDÉS ET DISPOSITIFS DE CLASSIFICATION DE CONDITIONS D'ACTIFS DE RÉSEAU ÉLECTRIQUE

(30) Priority: 22.01.2018 US 201862620076 P
(43) Date of publication of application: 24.07.2019
(73) Proprietor: Hitachi Energy Switzerland AG, 5400 Baden (CH)
(72) Inventor: Cheim, Luiz, 27603 Raleigh North Carolina (US)
(74) Representative: Vossius & Partner Patentanwälte Rechtsanwälte mbB

(56) References cited:
- EP-A1- 3 043 447
- WO-A1-2012/142355
- WO-A2-2014/078830
- US-A1- 2014 222 355

## Description

### FIELD OF THE INVENTION

The invention relates to methods and devices for monitoring or analyzing power network assets. The invention relates in particular to methods and devices that perform a condition classification of power network assets, such as power transformers.

### BACKGROUND OF THE INVENTION

A power system comprises a network of electrical components or power system equipment configured to supply, transmit, and/or use electrical power. For example a power grid comprises generators, transmission systems, and/or distribution systems. Generators, or power stations, are configured to produce electricity from combustible fuels (e.g., coal, natural gas, etc.) and/or noncombustible fuels (e.g., such as wind, solar, nuclear, etc.). Transmission systems are configured to carry or transmit the electricity from the generators to loads. Distribution systems are configured to feed the supplied electricity to nearby homes, commercial businesses, and/or other establishments. Among other electrical components, such power systems may comprise one or more power transformers configured to transform electricity at one voltage (e.g., a voltage used to transmit electricity) to electricity at another voltage (e.g., a voltage desired by a load receiving the electricity).

Monitoring and analysis of power network assets, such as power transformers, is an important task, because it can mitigate the risk of power system failure and ensure that actions are taken in a timely manner to ensure reliable operation of the power network assets, before failure occurs.

The identification of a condition that indicates that a power network asset requires attention is a considerable challenge. For illustration, power transformers are complex high-cost assets that are subject to ageing and other phenomena that may affect their reliability and operation. Various tools have been developed to assist an engineer in identifying conditions of power network assets that require some action to be taken.

WO 2014/078830 A2 discloses a method that comprises predicting an oil temperature of a transformer of a power system for a desired load based upon a profile of the transformer developed via a machine-learning algorithm.

CN 102 735 760 A discloses a method of predicting transformer oil chromatographic data based on an extreme learning machine.

CN 102 944 796 A discloses a fault diagnosis method for a power transformer that is based on an extreme learning machine.

EP 3 043 447 A1 discloses a system that can generate a heavy load pre-warning or an overload pre-warning for distribution transformers. A model may be trained, tested, and tuned based on a subset of variables.

The accuracy of a tool that automatically processes parameters of a power network asset for monitoring, diagnosis, or analysis is expected to increase when it is capable of taking into consideration values of a larger number of parameters. Various limitations are conventionally associated with tools that process a large number of inputs. For illustration, when a tool is capable of automatically processing a large number of parameter values associated with a power network asset, the performance may be good when all of those parameter values are available for a given power network asset. However, the tool may be incapable of analyzing the condition of a different power network asset for which not all of the required parameter values are available, or may be capable of analyzing the condition only partially. The lack of information on the expected reliability of the tool when not all of the required parameter values are available may also present an obstacle.

Missing parameter values for a power asset may have various reasons and may be caused, e.g., by the absence of certain sensors or by the lack of information on parameters such as age of the power transformer.

It may be challenging to adequately train a tool capable of automatically processing a large number of parameter values, because historical data that can be used for the training process may include all the parameter values for just a small number of power network assets. Analysis tools that use a smaller number of parameter values may be easier to train, but may not provide adequate reliability.

### SUMMARY

It is an object of the invention to provide improved methods, devices, systems, and computer-readable instructions that perform a condition classification of a power network asset. It is in particular an object to provide improved methods and devices that are capable of reliably performing a condition classification even if not all input parameter values required by an automatic classification procedure are available.

According to the invention, a method, an electronic device, and machine-readable instruction code as recited in the independent claims are provided. The dependent claims define embodiments.

According to the invention, methods and devices are provided which are capable of performing a condition classification for a power network asset. The methods and devices combine an automatic classification procedure that requires a set of parameter values as inputs with a missing data replacement procedure. The missing data replacement procedure provides substitute values for each required parameter value that is not available for a given power network asset. The missing data replacement procedure may be invoked when training the automatic classification procedure (e.g., to provide substitute values for those portions of the historical data that lack parameter values) and when using the automatic classification procedure for online or offline condition classification of a power network asset (e.g., by invoking the missing data replacement procedure to provide substitute values when some of the required parameter values are not available for the power network asset for which condition classification is performed).

According to the invention, a method of monitoring or analyzing a power network asset of a power network comprises: performing, by an electronic device, an automatic classification procedure for a condition classification of the power network asset, wherein the automatic classification procedure performs the condition classification using a set of parameter values as inputs, and wherein only a subset of the set of parameter values is available for the power network asset and at least one parameter value of the set is not available for the power network asset. The method further comprises performing, by the electronic device, a missing data replacement procedure to determine at least one substitute parameter value, and using the subset of parameter values and the at least one substitute parameter value in combination as inputs for the automatic classification procedure to obtain the condition classification of the power network asset.

According to the invention, an electronic device comprises an interface to receive data associated with a power network asset, and a processing device configured to perform an automatic classification procedure for a condition classification of the power network asset, wherein the automatic classification procedure is operative to use a set of parameter values as inputs, and wherein only a subset of the set of parameter values is available for the power network asset and at least one parameter value of the set is not available for the power network asset. The processing device is further configured to perform a missing data replacement procedure to determine at least one substitute parameter value, and use the subset of parameter values and the at least one substitute parameter value in combination as inputs for the automatic classification procedure to obtain the condition classification of the power network asset.

According to the invention, there is provided a power network which comprises a power network asset and an electronic device. The electronic device comprises an interface to receive data associated with the power network asset, and a processing device configured to perform an automatic classification procedure for a condition classification of the power network asset, wherein the automatic classification procedure is operative to use a set of parameter values as inputs, and wherein only a subset of the set of parameter values is available for the power network asset and at least one parameter value of the set is not available for the power network asset. The processing device is further configured to perform a missing data replacement procedure to determine at least one substitute parameter value, and use the subset of parameter values and the at least one substitute parameter value in combination as inputs for the automatic classification procedure to obtain the condition classification of the power network asset. The power network asset may be a transformer, in particular a power transformer, or a generator, without being limited thereto.

According to the invention, there is provided a set of machine-readable instructions that cause a processor of an electronic device to perform the following steps: performing an automatic classification procedure for a condition classification of a power network asset, wherein the automatic classification procedure performs the condition classification using a set of parameter values as inputs, wherein only a subset of the set of parameter values is available for the power network asset and at least one parameter value of the set is not available for the power network asset; performing a missing data replacement procedure to determine at least one substitute parameter value; and using the subset of parameter values and the at least one substitute parameter value in combination as inputs for the automatic classification procedure to obtain the condition classification of the power network asset.

According to the invention, there is provided a method of providing an automatic classification procedure for a condition classification of a power network asset. The method comprises training a machine learning algorithm that uses a set of parameter values as inputs to perform a condition classification, wherein the training is performed using training data associated with a plurality of power network assets; and performing a missing data replacement procedure when training the machine learning algorithm, the missing data replacement procedure generating substitute parameter values where at least one of the parameter values of the set is missing in the training data.

According to the invention, there is provided a set of machine-readable instructions that cause a processor of an electronic device to perform the following steps for providing an automatic classification procedure for a condition classification of a power network asset: training a machine learning algorithm that uses a set of parameter values as inputs to perform a condition classification, wherein the training is performed using training data associated with a plurality of power network assets; and performing a missing data replacement procedure when training the machine learning algorithm, the missing data replacement procedure generating substitute parameter values where at least one of the parameter values of the set is missing in the training data.

The methods, devices, and machine-readable instruction code according to the invention mitigate missing data problems that are conventionally encountered for automatic condition classification when the number of inputs of the automatic condition classification is so large that it is likely that one or several ones of the parameter values required by the automatic condition classification may not be available for a power network asset.

Embodiments of the invention may be used for determining whether a transformer, in particular a power transformer, or another power network asset operates normally or whether the transformer requires attention, without being limited thereto.

Embodiments of the invention may be used for performing an automatic condition classification with good reliability, even when part of the parameter values used as inputs by the automatic condition classification are not available for a given power network asset. Embodiments of the invention may be particularly useful in cases where one or several of the parameter values required as inputs by the automatic condition classification are not monitored online for a power network asset, for example without being limited thereto.

### BRIEF DESCRIPTION OF THE DRAWINGS

The subject-matter of the invention will be explained in more detail with reference to preferred exemplary embodiments which are illustrated in the attached drawings, in which:
Fig. 1 is a schematic representation of a power network comprising an electronic device for condition classification according to an embodiment.
Fig. 2 is a flow chart of a method according to an embodiment.
Fig. 3 is a flow chart of a method of adapting an automatic classification procedure according to an embodiment.
Fig. 4 is a flow chart of a method of performing a condition classification of a power network asset according to an embodiment.
Fig. 5 is a schematic representation illustrating the combination of automatic condition classification and missing data replacement according to an embodiment.
Fig. 6 shows exemplary data illustrating the problem of missing parameter values.
Fig. 7 illustrates missing parameter values in a large set of historical data.
Fig. 8 shows graphs illustrating an effect of a missing data replacement procedure on a statistical distribution of a parameter value when the missing data replacement procedure involves replacing the missing parameter value by a mean of a Gaussian statistical distribution.
Fig. 9 shows graphs illustrating an effect of a missing data replacement procedure on a statistical distribution of a parameter value when the missing data replacement procedure involves replacing the missing parameter value by a mean of a skewed Gaussian statistical distribution.
Fig. 10 shows graphs illustrating that a missing data replacement procedure does not affect a statistical distribution of a parameter value when the missing data replacement procedure involves replacing the missing parameter value by a random value determined in accordance with the statistical distribution, as an example of statistical multiple imputation.
Fig. 11A and Fig. 11B show a cross-correlation matrix of parameter values for use in a missing data replacement procedure in a method according to an embodiment.
Fig. 12A and Fig. 12B show a portion of the cross-correlation matrix of Fig. 11A and Fig. 11B including exemplary numerical correlation values.
Fig. 13 shows a Bayesian Network for a power transformer.
Fig. 14 shows a small portion of a Bayesian Network for a power transformer.
Fig. 15 is a flow chart of a method of according to an embodiment.
Fig. 16 is a schematic view illustrating an implementation of the method of Fig. 15.
Fig. 17 shows a graph representing a training evaluation for plural machine learning algorithms after training plural machine learning algorithms.
Fig. 18 shows a confusion table comparing performance of the automatic classification procedure with missing data replacement according to an embodiment with human expert classification.
Fig. 19 is a schematic representation showing the combination of automatic classification and missing data replacement according to an embodiment.
Fig. 20 shows a graph representing an effect of replacing different parameter values in a method according to an embodiment.
Fig. 21 is a schematic representation of a power network comprising an electronic device for condition classification according to an embodiment.
Fig. 22 is a flow chart of a method according to an embodiment.

### DETAILED DESCRIPTION OF EMBODIMENTS

Exemplary embodiments of the invention will be described with reference to the drawings in which identical or similar reference signs designate identical or similar elements. While some embodiments will be described in the context of power transformers, the methods and devices described in detail below may be used for a performing a condition classification of a wide variety of different power network assets. The features of embodiments may be combined with each other, unless specifically noted otherwise.

### Overview

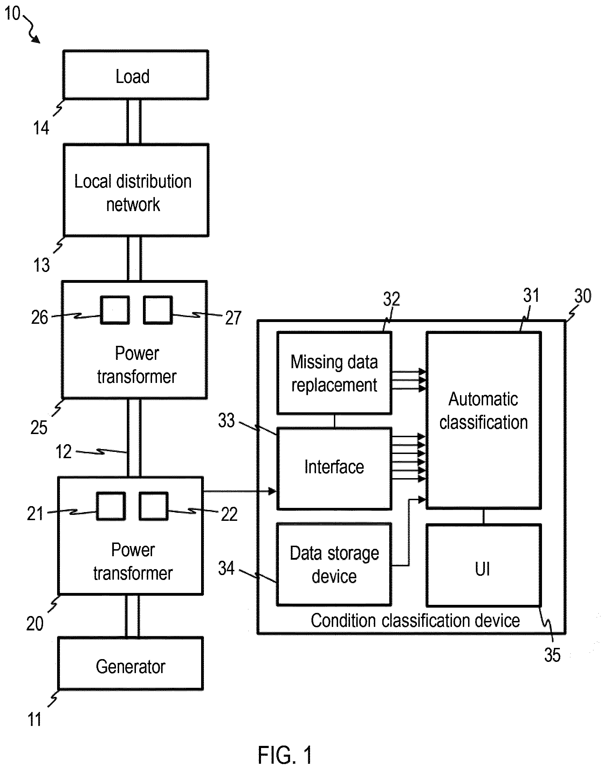

Fig. 1 shows a power network 10 in which methods and devices according to embodiments may be employed for a condition classification of a power network asset. The power network 10 may comprise a generator 11, a step-up power transformer 20, a transmission line 12, a step-down power transformer 25, a local distribution network 13, and one or several loads 14. The generator 11, power transformers 20, 25, and transformers in the local distribution network 13 are exemplary for power network assets.

In view of their importance for power network operation and reliability, an assessment of the condition of power network assets is performed. In order to assist an engineer in this task, a condition classification device 30 may automatically perform a condition classification of one or several power network assets. For illustration, and without being limited thereto, the condition classification device 30 may perform a condition classification of the power transformer 20 and, optionally, of one or several additional power transformers 25 or other power network assets.

The condition classification device 30 may be operative to output a condition classification that may have at least two different values. The at least two different values may represent
- a first class indicating that a power network asset operates normally ("good"); and
- a second class indicating that a power network asset requires attention ("bad").
The condition classification device 30 may be operative to output a condition classification that may have at least three different values. The at least three different values may represent
- a first class indicating that a power network asset operates normally;
- a second class indicating that a power network asset requires some attention; and
- a third class indicating that a power network asset requires immediate attention.
More than three classes may be used.

The condition classification device 30 receives data from sensor(s) 21, 22, 26, 27 that capture operational data associated with the power transformer(s) 20, 25 or other power network assets for which condition classification is to be performed. The condition classification device 30 may have an interface 33 for receiving data from the sensors that capture operational data associated with the power transformer(s) 20, 25 or other power network assets. The condition classification device 30 may be configured to process a wide variety of different parameter values to perform the condition classification, as will be explained in more detail below.

Additional parameter values associated with the power transformer(s) 20, 25 or other power network assets for which condition classification is to be performed may be stored in a data storage device 34. Such additional parameter values may include information on age, importance rating, construction type, nameplate data, or other information associated with the power network assets that is unlikely to change during ongoing operation of the power network asset. An engineer may input this information via a user interface 35, for example for storing in the data storage device 34 when a power network asset is installed, for example.

The condition classification device 30 may comprise an automatic classification module 31. The automatic classification module 31 may be configured to perform an automatic condition classification in response to a set of parameter values. The total number of values of different parameters in the set that are required as inputs by the automatic classification module 31 may be designated by N.

A subset of the set of parameter values may be available for a power network asset 20, 25 for which condition classification is to be performed. The total number of values of different parameters in the subset that is available for the power network asset for which condition classification may be designated by L.

The subset of parameter values that is available for the power network asset may include parameter values that are provided by sensors 21, 22, 26, 27 installed on the power network asset for which condition classification is to be performed. L₁ parameter values for the power network asset for which condition classification is to be performed may be received at the interface 33, while L₂ parameter values may be retrieved from a data storage device 34, wherein L₁ + L₂ = L.

The condition classification device 30 according to embodiments is configured in such a way that it can perform an automatic condition classification even when the number L of values for different parameters that is available for a power network asset is less than the total number N of values of different parameters that is required by the automatic classification module 31 as inputs. In order to accommodate the missing parameter values, the condition classification device 30 comprises a missing data replacement module 32. The missing data replacement module 32 may provide substitute values for those M = N - L values for parameters that are required by the automatic classification module 31 to perform a condition classification, but which are not available for the power network asset for which condition classification is to be performed.

The missing data replacement module 32 may use any one of a variety of different missing data replacement techniques, as will be explained in more detail below.

The missing data replacement module 32 may determine at least one of the substitute parameter values required as input for the automatic classification module 31 as a function of the L parameter values that are available for the power network asset.

The automatic classification module 31 and missing data replacement module 32 may be implemented by hardware, firmware, software, other machine-readable instruction code, or a combination thereof. The condition classification device 30 may comprise at least one integrated semiconductor circuit to implement the function of the automatic classification module 31 and the missing data replacement module 32. The at least one integrated semiconductor circuit may comprise one or several of a microprocessor, a processor, a microcontroller, a controller, an application specific integrated circuit, or any combination thereof.

While the operation of the condition classification device 30 will mainly be described with reference to the condition classification of one power network asset, such as power transformer 20, it will be appreciated that in a realistic operation scenario the condition classification device 30 can normally perform a condition classification for a plurality of power network assets that operate in the same power network 10 or that may even be installed in different power network. For illustration, the condition classification device 30 may perform a condition classification for a plurality of power transformers 20, 25, either simultaneously or sequentially.

When the condition classification device 30 performs a condition classification for plural power network assets, different parameter values may be missing for different power network assets, even when the power network assets are all of the same type (such as power transformer). In this case, the missing data replacement module 32 may provide substitute values for different missing parameter values of the different power network assets. For illustration, a substitute value for a first parameter of the power transformer 20 may be provided by the missing data replacement module 32 for a condition classification of the power transformer 20. A substitute value for a second parameter of the power transformer 25 may be provided by the missing data replacement module 32 for a condition classification of the power transformer 25. The missing data replacement module 32 may use different missing data replacement procedures depending on which one of the parameter values required by the automatic classification module 31 is not available for the respective power network asset.

In the condition classification, the automatic classification module 31 may process an input it receives in the same way, irrespective of whether the input is an actual (for example measured) parameter value of the power network asset or whether the input is a substitute value generated by the missing data replacement module 32. For illustration, a gas concentration relating to a dissolved gas in an insulating oil of a power transformer may be processed in the same way by the automatic classification module 31 irrespective of whether the value for this parameter is measured at the power transformer 20 or whether it is generated by the missing data replacement module 32.

The condition classification device 30 according to an embodiment may combine automatic classification, which may be implemented by a machine learning algorithm, with missing data replacement. This allows the condition classification device 30 to perform an automatic classification procedure that uses a comparatively large number N of parameter values as inputs, rendering the automatic classification procedure reliable, while autonomously compensating for missing parameter values that may not be available for some of the power network assets. Those parameter values that are not available may be replaced by substitute values that are determined by performing a missing data replacement procedure.

It will be appreciated that there may be various reasons that can cause at least one of the parameter values required by the automatic classification module 31 to be not available for a power network asset. Exemplary scenarios include the following:
- The power network asset for which condition monitoring classification is to be performed is not equipped with a sensor that would be suitable to capture a parameter value required as input by the automatic classification module 31.
- A parameter value required as input by the automatic classification module 31 may be a parameter value that is typically determined in laboratory test environments or by theoretical modeling, but which is not readily accessible by a measurement during online operation of the power network asset.
- The automatic classification module 31 has been enhanced to take into account a new, additional parameter value as input, for which no online or offline data is available. In such cases, it may be challenging or undesirable in view of cost considerations to provide the power network asset with the required sensors that can capture the new, additional parameter value.
- A parameter value required as input by the automatic classification module 31 may be a nonnumeric parameter character such as, for example any parameter character in the list {/, -, --, ^{∗}, b, etc.} that resulted from human imputation in the absence of numerical values to fulfill the data requirement.

Without limitation, the automatic classification module 31 may be configured such that it processes a number N of different parameter values, with N being greater than 10, greater than 50, or even greater than 90, to perform the condition classification. At least part of the number N of different parameter values required as inputs by the automatic classification module 31 may be generated by the missing data replacement module 32.

While the generation of a substitute value for each parameter value that is not available for a power network asset, but which is required as input by the automatic classification module 31, allows the condition classification to be performed, it may affect the accuracy of the obtained condition classification. The condition classification device 30 may be operative to determine an indicator for the accuracy, e.g., a confidence level, of the condition classification in dependence on how many substitute values have been inputted to the automatic classification module 31 and/or in dependence on which parameters are affected by the inputting of the substitute values.

The condition classification device 30 may output a result of the condition classification. Optionally, the condition classification device 30 may output information on the accuracy, e.g., a confidence level, of the result of the condition classification in dependence on which parameter value(s) is/are not available for the power network asset.

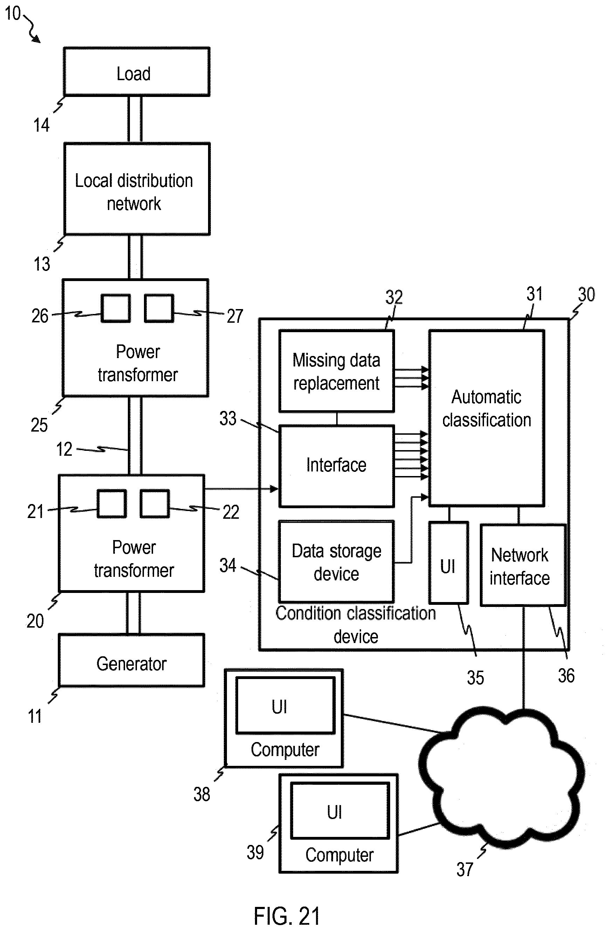

The condition classification device 30 may comprise a user interface 35 for outputting the result of the condition classification and, optionally, information on the accuracy. Alternatively or additionally, the condition classification device 30 may comprise a data network interface for outputting data indicating the result of the condition classification and, optionally, the information on the accuracy. This allows the results of the condition classification to be accessed by a terminal device that may be remote from the condition classification device 30, as will be explained in more detail with reference to Fig. 21.

The automatic classification procedure performed by the condition classification device 30 may comprise a machine learning technique. The machine learning technique may be trained using historical data or other training data previously acquired for a plurality of power network assets of the same asset type as the power network asset for which condition classification is to be performed. For illustration, in order to perform a condition classification of a power transformer or of several power transformers installed in a power network 10, the automatic classification procedure 31 may comprise one or several machine learning algorithms that have been trained with historical data for a plurality of power transformers. Missing data replacement procedures may be performed not only for determining a condition classification of a power network asset during operation, but also when training a machine learning technique.

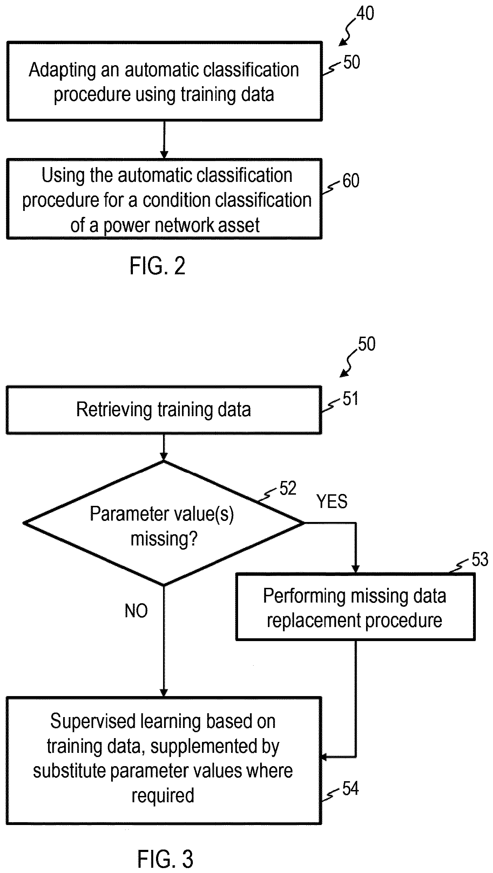

Exemplary methods and scenarios in which the combination of an automatic classification procedure with missing data replacement may be used will be described with reference to Fig. 2 to Fig. 22 in the following. It will be appreciated that a wide variety of different automatic classification procedures and/or a wide variety of different missing data replacement procedures may be used, in addition or as an alternative to the techniques described herein in detail. The methods described in detail herein may be applied to a wide variety of power network assets, including transformers (such as, without limitation, power transformers, distribution transformers, or high voltage transformers) or generators, without being limited thereto.

Fig. 2 is a flow chart of a process 40 according to an embodiment. The process 40 comprises a method 50 of adapting an automatic classification procedure for power network asset condition classification, and a method 60 that uses the automatic classification procedure for a condition classification of a power network asset. It will be appreciated that the methods 50, 60 will typically be performed on different computers and at different times. For illustration, the method 50 of adapting an automatic classification procedure to a type of power network asset (such as power transformer) using training data results in an automatic classification procedure that is specifically adapted for performing a condition classification of this type of power network asset. After training, software, firmware, or other machine readable instruction code that includes the automatic classification procedure may be deployed for use by an engineer, e.g., during online monitoring of a power network 10 or for offline analysis of power network assets.

The automatic classification procedure that has been trained for power network asset condition classification in the method 50 may comprise a machine learning algorithm or plural different machine learning algorithms. The machine learning algorithm(s) may comprise linear algorithms, nonlinear algorithms, and ensemble algorithms. The method 50 of adapting an automatic classification procedure to a type of power network asset (such as power transformer) may comprise training a plurality of different machine learning algorithms and selecting one or some of the machine learning algorithms as a function of a performance evaluation. The plurality of different machine learning algorithms that is trained in the method 50 may comprise at least one linear algorithm selected from a group consisting of general linear regression (GLM) and linear discriminant analysis (LDA). Alternatively or additionally, the plurality of different machine learning algorithms that is trained in the procedure 50 may comprise at least one nonlinear algorithm selected from a group consisting of classification and regression trees (CART), a Naive Bayes algorithm (NB), Bayesian networks, K-nearest neighbor (KNN), and a support vector machine (SVM). Alternatively or additionally, the plurality of different machine learning algorithms that is trained in the method 50 may comprise at least one ensemble algorithm selected from a group consisting of random forest, tree bagging, an extreme gradient boosting machine, and artificial neural networks.

The method 50 may also comprise performing a missing parameter replacement procedure. For illustration, the training data may comprise historical data associated with a plurality of power network assets. While it is desirable to provide an automatic classification procedure that can take advantage of a comparatively large number of inputs, the number of parameter values that is available for each one of the power network assets in the training data may be fairly small or even zero. For illustration, the training data may include a large number of data sets. Each data set may be associated with historical data of a real power transformer or other power network asset. In some or all of the data sets (which may be thought of as lines or columns in a large table of training data), at least one parameter value may be missing. Therefore, missing data replacement may be used also during the training, so as to replace those parameter values that are not available for a power network asset in the training data by substitute values in each one of the data sets.

In the method 60, the use of the automatic classification procedure may involve performing a missing data replacement procedure. Missing data replacement in the methods 50 and 60 serve somewhat different, albeit related purposes: missing data replacement in the method 50 at least partially compensates for the fact that not all parameter values that can be input to the various machine learning algorithms during the training may be available for all data sets of the training data. The missing data replacement in method 60 at least partially compensates for the fact that not all parameter values that are required as inputs by the trained automatic classification procedure may be available for a power network asset for which condition classification is to be performed.

Fig. 3 is a flow chart of the method 50 of adapting an automatic classification procedure for a condition classification of a power network asset, with the adaptation being performed using training data associated with power network assets. At step 51, training data is retrieved. The training data may be retrieved from a data repository. The training data may comprise historical data associated with a number of power network assets having the same asset type, such as power transformer, as the power network asset for which condition classification is to be performed. The training data may comprise in excess of 100, preferably in excess of 500, preferably at least about 800 historical data sets, each respectively associated with a power network asset.

At step 52, it is determined whether a parameter value that should be input into a machine learning algorithm during the training is missing in the training data for at least one of the data sets in the training data. If a parameter value is missing, the missing data replacement procedure is performed at step 53 to generate a substitute value for the missing parameter value. If no parameter value is missing for a data set associated with a power network asset in the training data (which is a very unlikely scenario if the number of parameter values input into the machine learning algorithm is large), the method may directly proceed from step 52 to step 54.

At step 54, supervised learning may be performed. The supervised learning may be based on the training data, supplemented by substitute values generated by the missing data replacement procedure performed at step 53 where required. The supervised learning may use the training data in combination with an assessment of the power network condition that is given by a human expert.

As will be appreciated by the skilled person, "machine learning" involves a semi-automated process of knowledge extraction from data using algorithms that are not explicitly programmed. The process is semi-automated because machine learning requires human-data interaction (e.g., for data cleansing, etc.). Machine learning generally refers to a vast set of tools that can be utilized to extract knowledge from data. Various algorithms known to the skilled person may be put to use for condition classification of a power network asset. Examples of such algorithms include, without limitation, linear algorithms, such as general linear regression (GLM) and linear discriminant analysis (LDA); nonlinear algorithms, such as classification and regression trees (CART), a Naive Bayes algorithm (NB), Bayesian networks, K-nearest neighbor (KNN), and a support vector machine (SVM); and ensemble algorithms, such as random forest, tree bagging, an extreme gradient boosting machine, and artificial neural networks.

In the supervised learning performed at step 54, machine learning maps the complex relationship between the feature space and the condition classification, which is the output variable of the machine learning algorithm. The output provided by the machine learning algorithm is compared to the human expert classification, to improve and enhance the accuracy of the classification obtained by the machine learning algorithm. In unsupervised learning, the machine learning searches for hidden structures in data.

While only general steps of the training method 50 are shown in Fig. 3, it will be appreciated that the training method 50 may be considerably more complex. For illustration, adapting an automatic classification procedure for use with a certain type of power network assets may comprise training not only one, but several machine learning algorithms, respectively using supervised learning. Additionally or alternatively, more than one missing data replacement procedure may be used at step 53, as will be explained in more detail below.

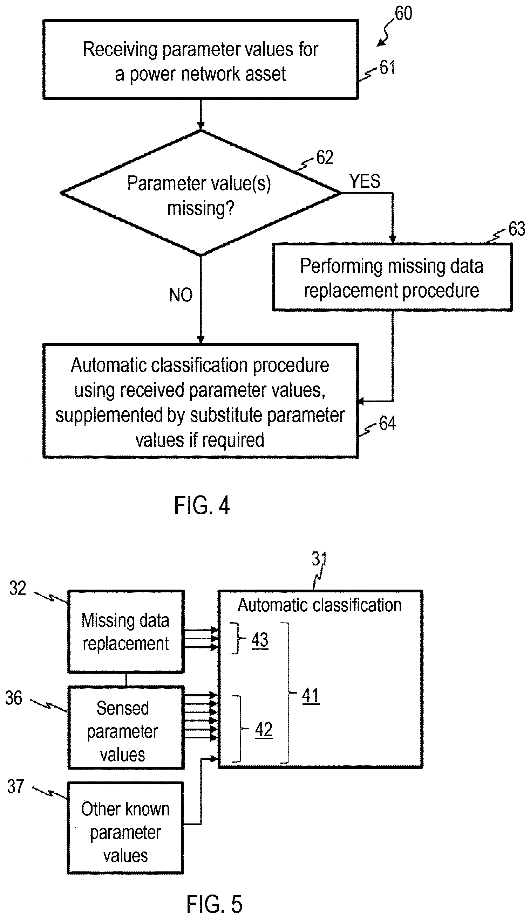

Fig. 4 is a flow chart of a method 60 of using an automatic classification procedure for performing a condition classification of a power network asset. The automatic classification procedure may be a machine learning algorithm. The automatic classification procedure may require a set of N parameter values as inputs.

At step 61, parameter values are received for a power network asset. The parameter values may be received from the sensors associated with the power network asset and/or from a data repository, as has been explained with reference to Fig. 1. The parameter values may comprise L₁ parameter values that are monitored online and L₂ parameter values that are retrieved from a data depository. The parameter values retrieved from the data repository may in particular include parameter values that typically do not change with time or change slowly as a function of time, such as age of the power network asset, a voltage class of the power network asset, or an importance rating of the power network asset. The parameter values retrieved from the data repository may include type-related parameters, such as nameplate information of the power network asset or of subsystems thereof. For illustration, information on a cooling system type, a bushing type, or an oil insulation system type of a power transformer may be retrieved from a data repository, where this information may be stored by an engineer.

At step 62, it is determined whether one of the N parameter values required by the automatic classification procedure as inputs is not available for the power network asset, i.e., whether L = L₁ + L₂ < N. For an automatic classification procedure that uses a fairly large number of inputs (e.g., more than 50 inputs), at least one parameter value is likely to be not available for any power network asset in the power network. Different parameter values may be missing for different power network assets (e.g., different transformers) for which a condition classification is performed.

At step 63, a missing data replacement procedure is performed to generate a substitute value for the at least one parameter value that is not available for the power network asset.

At step 64, an automatic classification procedure is performed. The automatic classification procedure uses the received parameter values as inputs, supplemented by the substitute values generated at step 63 for those inputs for which no data is available for a power network asset.

While only the general steps of the training method 60 are shown in Fig. 4, it will be appreciated that the classification method may be considerably more complex. For illustration, more than one missing data replacement procedure may be used at step 63, as will be explained in more detail below. Different missing data replacement procedures may be invoked depending on which ones of the parameter values required as inputs of the automatic classification procedure are missing and/or depending on how different missing data replacement procedures affect the accuracy of the condition classification.

Fig. 5 is a schematic block diagram representation illustrating the missing data replacement. The automatic classification module 31 requires a set 41 of parameter values as inputs for performing the condition classification. A subset 42 of the set 41 is available for a power network asset. The subset 42 may comprise parameter values 36 that are monitored, e.g., online during operation of the power network asset. The subset 42 may comprise other parameter values 37 that may be known in other ways. Data input via a user interface by an engineer and/or data stored in a data repository are exemplary for data that do not need to be provided by sensors. Nameplate information or information relating to the age, importance classification, or similar other parameters are exemplary for the parameter values 37 that do not need to be sensed by sensors.

At least one parameter value of the set 41 is neither included in the set of parameter values 36 nor in the other known parameter values 37. Substitute values 43 are determined by the missing data replacement module 32. The substitute values 43 are input as substitutes for actual (measured or otherwise known) parameter values that are included in the set 41 because they are required as input by the automatic classification module 31, but which are neither available as sensed parameter values 36 nor otherwise known for the power network asset.

At least one of the substitute values 43 may depend on the subset 42 of parameter values that is available for the power network asset. For illustration, and as will be explained in more detail below, correlations between different parameters or information on statistical distributions of parameter values may be used in the missing data replacement procedure to determine one or several of the substitute values.

### Exemplary embodiment: transformer condition classification

While the concepts disclosed herein are applicable to a wide variety of different power network assets, the methods, devices, and computer programs may be used for a condition classification of transformers. The parameter values used as inputs of the automatic classification procedure may include parameter values for which online monitoring is performed during operation of the power network asset and other parameter values for which no online monitoring is performed during operation of the power network asset. The parameter values used as inputs of the automatic classification procedure may include a parameter value that has been incorporated into the inputs of the automatic classification procedure after manufacture or installation of the power network asset, such that no information on this parameter value is available for the power network asset.

The techniques may be used, e.g., for a condition classification of a power transformer, a distribution transformer, or a high voltage transformer, which may be operative with voltages of at least 69 kV or at least 34.5 kV.

An automatic classification procedure may use various parameter values associated with the transformer as inputs.

The following provides non-limiting examples for parameter values that may be required (individually or in any combination) as inputs of the automatic classification procedure for a power network asset:
- age, voltage class, power, and/or importance rating;
- ThruFaults;
- information relating to an insulation system comprised by the power network asset; the information relating to the insulation system may include a system type of the insulation system or operational parameters of the insulation system; for an oil insulation system, the operational parameters may include one or several of an oil interfacial tension, an oil dielectric strength, an oil power factor, moisture in insulating oil of the oil insulation system of the oil insulation system, a concentration of at least one dissolved gas in insulating oil of the oil insulation system; the at least one gas may be selected from a group consisting of: H₂, CH₄, C₂H₂, C₂H₄, C₂H₆, CO, CO₂, O₂, and N₂;
- information relating to a winding comprised by the power network asset; the information relating to the winding may include one or several of a winding power factor, a winding capacitance, a winding temperature;
- information relating to a bushing comprised by the power network asset; the information relating to the bushing may include one or several of a bushing power factor, a bushing capacitance, a bushing type of the bushing;
- information relating to a cooling system comprised by the power network asset; the information relating to the cooling system may include a condition of the cooling system and/or a cooling system type of the cooling system;
- information relating to a load tap changer comprised by the power network asset; the information relating to the load tap changer may include a condition of the load tap changer and/or a load tap changer type of the load tap changer;
- a load of the power network asset; the load may be a dynamic load.

It will be appreciated that values of alternative or additional parameters may be used as inputs of the automatic classification procedure for other power network assets, such as generators.

### Missing parameter values and missing data replacement

### Missing parameter values

The problem that parameter values required as inputs for an automatic classification procedure may not be available may occur both when training the automatic condition classification for subsequent use in power network asset condition classification and when using the trained automatic classification procedure. In either case, missing data replacement procedures may be performed to provide substitute values when part of the required inputs are missing for a power network asset. The missing data replacement procedures disclosed herein may be used in association with any one of the methods, devices, systems, and machine-readable instruction codes disclosed herein.

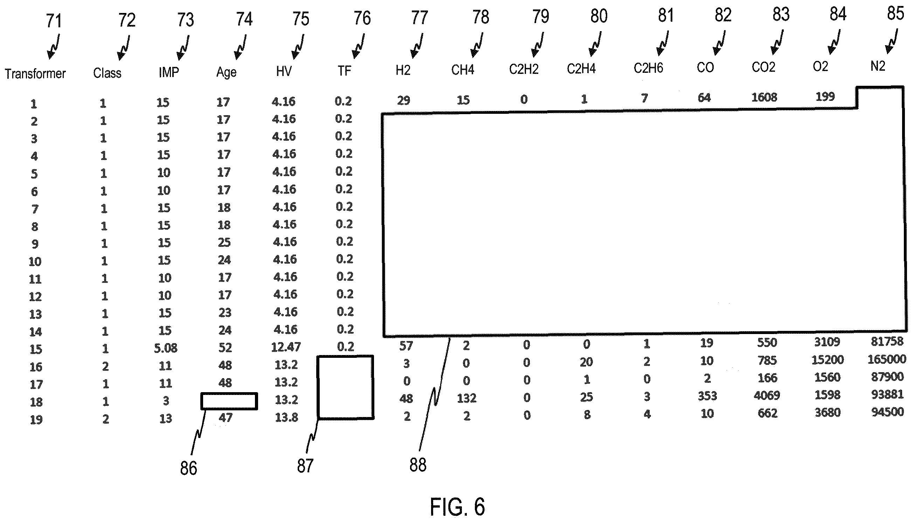

Fig. 6 illustrates exemplary data for power network assets, which respectively are power transformers. A table as illustrated in the Fig. 6 may be encountered both when a condition classification is performed using a trained automatic classification procedure, and during training of an automatic condition classification procedure.

The table includes exemplary columns, which are provided for illustration and which are not exhaustive. For illustration, a data column 71 may include an identifier for each power network asset. A data column 72 may include a parameter value representing a class of the respective power network asset. A data column 73 may include a parameter value representing an importance rating of the respective power network asset. A data column 74 may include a parameter value representing an age of the respective power network asset. A data column 75 may include a parameter value representing a voltage class of the respective power network asset. A data column 76 may include a parameter value representing a ThruFault of the respective power network asset. Data columns 77-85 may include parameter values representing dissolved gas concentrations in insulating oil of an oil insulation system for the gases H₂, CH₄, C₂H₂, C₂H₄, C₂H₆, CO, CO₂, O₂, and N₂.

Parameter values are missing in areas 86, 87, and 88 of the table. For illustration, the age information is missing for a transformer in area 86 of the table. ThruFaults are missing for transformers in area 87 of the table. Gas concentrations are missing for various other transformers in area 88 of the table.

If the missing data is encountered during operation of a condition classification device in accordance with an embodiment, substitute values may be determined that are used where real data is missing in areas 86, 87, and 88 of the table. The determination of substitute values may be performed automatically and autonomously by the condition classification device.

If the missing data is encountered during the adaptation of the automatic classification procedure, e.g., during training a machine learning algorithm, substitute values may be input to the supervised learning procedure.

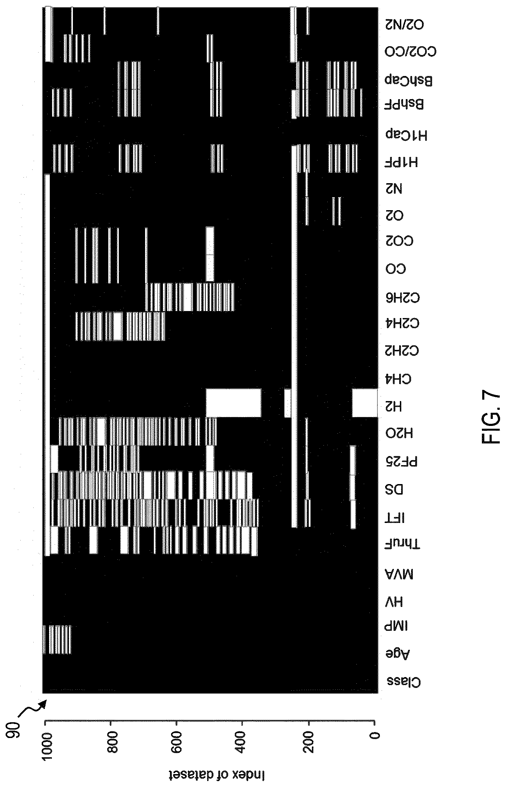

Fig. 7 illustrates training data 90 including data sets for 1000 power transformers. Fields that contain data are indicated by a black line. Fields that do not contain data are indicated by a white line. When the training data 90 are used for adapting an automatic classification procedure for performing a condition classification of a power transformer, at least one missing data replacement procedure is invoked to provide substitute values where no data is included in the data sets of the training data 90.

As will be appreciated from Fig. 6 and Fig. 7, different parameter values may generally be missing for different data sets. For illustration, information on an age may not be available in one data set, while information on the gas concentrations, moisture in insulating oil, or information on a bushing power factor or capacitance may be missing in other data sets. More than one missing data replacement procedure may be used, depending on which parameter value is missing or to identify an optimum missing data replacement procedure from among a plurality of different missing data replacement procedures.

The missing data replacement procedure(s) which may be used may include the following:
- using a default value;
- using a mean or median value of a statistical distribution;
- using a random value determined in accordance with a statistical distribution;
- hard value imputation;
- using a value determined based on parameter correlations.

Exemplary implementations of such missing data replacement procedures will be explained below.

For brevity, parameter values that are required as inputs for a machine learning algorithm or a trained automatic classification procedure will be referred to as "missing parameter values" in the following. It will be appreciated that a missing parameter value always is to be understood with reference to a respective power network asset or data set of the training data. I.e., while a given parameter value may not be available for a power transformer 20, the respective parameter value may be available for another power transformer 25 in the power network. Similarly, while a given parameter value may not be available for a data set in the training data, the respective parameter value is available for another data set in the training data.

### Determining a substitute value for a missing parameter as a default value

A substitute value for a missing parameter value may be a default value. The default value may be fixed. The default value may depend on which parameter value is missing. The default value may also depend on the parameter values that are available for the power network asset.

### Determining a substitute value for a missing parameter as a mean or median value of a statistical distribution

A substitute value for a missing parameter value may be determined as a mean or median value of a statistical distribution for this parameter value. The statistical distribution may be determined, e.g., from those data sets in the training data that include the parameter value that is missing in another data set.

As illustrated in Fig. 7, even when a parameter value is missing for some of the power network assets, the value for the respective parameter will typically be available for a large number of power network assets of the same type (such as power transformer). This allows a statistical distribution for the parameter value to be determined. Alternatively or additionally, physical modeling may be used to determine the statistical distribution. The statistical distribution may not only be used when training a machine learning algorithm, but also during subsequent operation of the condition classification device 30.

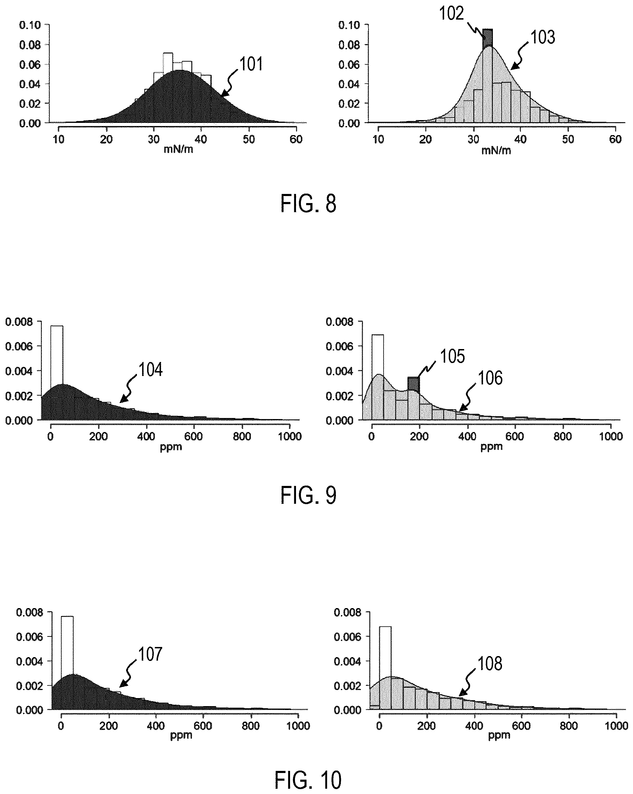

Fig. 8 and Fig. 9 illustrate the effect of replacing missing parameter values by a mean or median value of a statistical distribution. Fig. 8 illustrates a normal statistical distribution of a parameter value. A statistical distribution as illustrated in Fig. 8 may be found, e.g., for interfacial tension (ITF) of oil. A statistical distribution 101 illustrates the oil interfacial tension for those power transformers for which the oil interfacial tension is known. The mean or median value of the statistical distribution 101 can be used as a substitute value for the missing interfacial tension for those power transformers for which this parameter value is not known. This is illustrated by the increased length of the histogram bar 102 on the right-hand side of Fig. 8. The modified statistical distribution 103 that is obtained by also taking into account the substitute values that correspond to the mean or median value of the original statistical distribution 101 has the same mean or median value as the original statistical distribution 101, but a decreased standard deviation.

Fig. 9 illustrates a skewed normal statistical distribution of a parameter value. A statistical distribution as illustrated in Fig. 9 may be found, e.g., for a dissolved gas concentration of CO in oil. A statistical distribution 104 illustrates the dissolved gas concentration of CO for those power transformers for which the dissolved gas concentration of CO is known. The mean or median value of the statistical distribution 104 can be used as a substitute value for the missing dissolved gas concentration of CO for those power transformers for which this parameter value is not known. This is illustrated as increased length of the histogram bar 105 on the right-hand side of Fig. 9. The resultant modified statistical distribution 106 that is obtained by also taking into account the substitute values that correspond to the mean or median value of the original statistical distribution 104 has the same mean or median value as the original statistical distribution 104, but distorts the statistical distribution to a non-normal distribution.

### Determining a substitute value for a missing parameter as a random number selected according to a statistical distribution

A substitute value for a missing parameter value may be determined as a random value in accordance with a statistical distribution for this parameter value. I.e., the substitute value may be a random number that is selected in accordance with a statistical distribution for that parameter value. The statistical distribution may be determined, e.g., from those data sets in the training data that include the parameter value that is missing in another data set. The statistical distribution may alternatively be determined by physical models or by experiments.

Fig. 10 illustrates a skewed normal statistical distribution of a parameter value. A statistical distribution as illustrated in Fig. 10 may be found, e.g. for a dissolved gas concentration of CO in oil. A statistical distribution 107 illustrates the parameter value for those power transformers for which the parameter value is known. When the substitute values that replace the missing parameter value for one or several power transformers are respectively determined in accordance with the statistical distribution 107, the resultant statistical distribution 108 that includes those power transformers for which the substitute values have been determined as random values selected in accordance with the statistical distribution 107 is identical to the original statistical distribution 107.

### Determining a substitute value for a missing parameter by hard value imputation

A substitute value for a missing parameter value may be determined by hard value imputation. The substitute value may be based on an educated guess. During training of the automatic classification procedure, the educated guess may be provided by a human expert. During operation of the condition classification device 30, when hard value imputation is used, information on the educated guess may be retrieved from a storage device. The storage device may store educated guess values for a plurality of different parameter values.

### Determining a substitute value for a missing parameter based on parameter correlations

A substitute value for a missing parameter value may be determined by using correlations between parameters. For illustration, even when some parameter values are missing in most or all of the data sets of the training data, as illustrated in Fig. 6 and Fig. 7, parameter correlations may be determined between the parameter values that are present. The parameter correlations may be multivariate correlations or Pearson correlations. A correlation matrix indicating the correlation between parameter values may be obtained thereby.

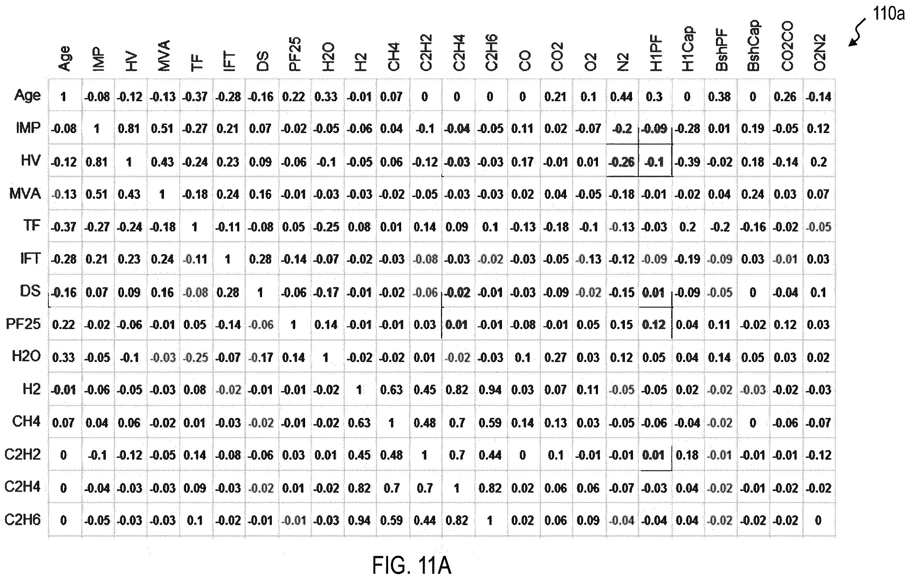

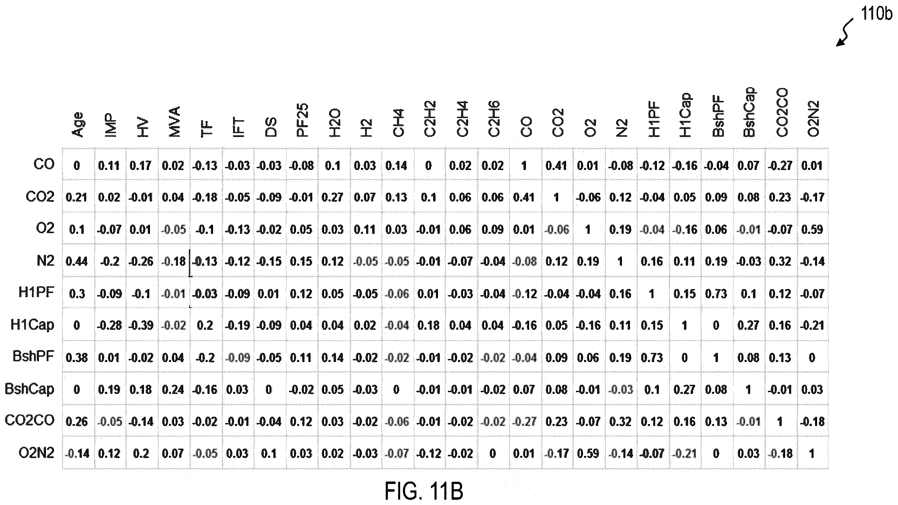

Fig. 11A and Fig. 11B show two halves 110a, 110b of one correlation matrix that reflects the correlations between different parameter values. The exemplary correlation matrix has rows and columns for the following parameters: age (age), importance (IMP), voltage class (HV), power (MVA), ThruFaults (TF), interfacial tension of oil (IFT), oil dielectric strength (DS), oil power factor (PF25), moisture in oil (H₂O, a concentration of dissolved gases in oil (H₂, CH₄, C₂H₂, C₂H₄, C₂H₆, CO, CO₂, O₂, N₂), high voltage winding power factor (H1PF), high voltage winding capacitance (H1Cap), bushing power factor (BshPF), bushing capacitance (BshCap), and other derived ratios from the existing parameters such as for example CO₂/CO and O₂/N₂ (O2N2).

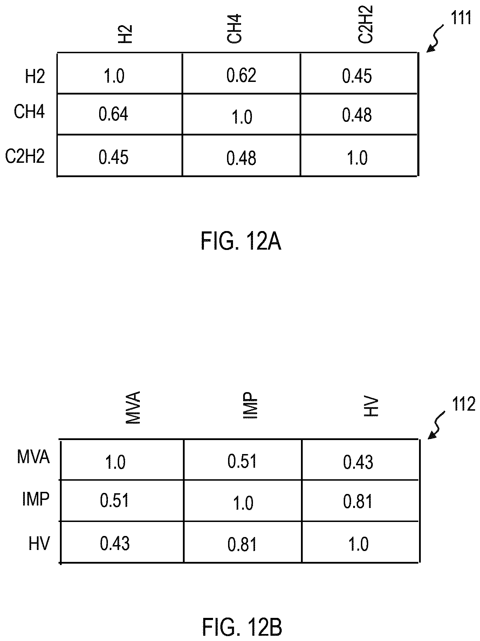

Correlated parameters may be identified based on the correlation matrix. Exemplary islands of higher correlation are reproduced separately in Fig. 12A and Fig. 12B. Fig. 12A shows a part 111 of the correlation matrix 110a, 110b that reflects the correlations between the dissolved gas in oil concentrations for H₂, CH₄, and C₂H₂. Fig. 12B shows a part 112 of the correlation matrix 110a, 110b that reflects the correlations between power, importance, and voltage class.

The correlation matrix may be used to determine substitute value(s) for one or several missing parameter values of a power network asset, using those parameter values of the power network asset that are known and by combining this information with the correlations 110a, 110b determined from a large set of power network assets. Multivariate regression or Pearson correlations may be used to determine the substitute value(s) for one or several missing parameter values of a power network asset in this way.

### Other missing data replacement procedures

Other missing data replacement procedures may also be used. For illustration, a Probabilistic Belief Propagation Algorithm that uses Conditional Probability Tables (CPTs) may be employed to determine substitute values for missing parameter values, taking into consideration those parameter values of the power network asset that are known.

### Selection of a missing data replacement procedure

Some missing data replacement procedures may outperform other missing data replacement procedures. The best-performing missing data replacement procedure may depend on which parameter value is missing and/or which machine learning technique is used to implement the automatic classification procedure.

The condition classification device 30 according to an embodiment may be configured to perform at least one missing data replacement procedure. More than one missing data replacement procedure may be supported, such as single imputation (educated guess, mean or even median value of a distribution), feature correlation (i.e., making the missing data a function of all other parameters), multiple imputation (i.e., finding the probability distribution function that best adhere to the data), and use of probabilistic belief propagation algorithms (such as in Bayesian Networks). One or several suitable missing data replacement procedures may be implemented in the condition classification device 30. Depending on the parameter values that are available for a power network asset and/or depending on the missing parameter for which a substitute value is to be determined, one of the missing data replacement procedures may be invoked to determine the substitute value.

For illustration, a missing data replacement procedure that uses parameter correlations may be used if there is a sufficient, but not too strong correlation or anti-correlation between the parameter value for which the substitute value is to be determined and other parameter value(s) that are known for the power network asset. If the correlation has a magnitude that is close to 1 (i.e., perfectly correlated or anti-correlated parameters), the missing data replacement procedure that uses parameter correlations may not add information when it is used to determine the substitute value for the missing parameter value.

For further illustration, if a good educated guess is available for a given parameter value, the educated guess may be used.

During the method of adapting an automatic classification procedure to a training set (method 50 in Fig. 2 and Fig. 3), several different missing data replacement procedures may be used sequentially. Suitable missing data replacement procedures may be identified using a performance evaluation of the automatic classification procedure after training the machine learning algorithm, respectively for different missing data replacement procedures, and selecting a missing data replacement procedure that shows good performance.

Machine learning algorithms may be used to evaluate the impact of different types of missing data replacement strategies on the accuracy of the best trained machine learning algorithm.

### Automatic classification procedure and machine learning algorithms

The automatic classification procedure performed by the condition classification device 30 may be or may comprise a machine learning algorithm that has previously been trained with training data associated with a plurality of power network assets. Different machine learning algorithms may be used, as has been explained above.

Generally, training an automatic classification procedure for use with power network assets may include:
(a) Selecting a candidate technique (e.g., Linear Regression, Logistic Regression, ANN, Classification Trees, etc.).
(b) Select a training dataset with the attributes of the power network asset to be classified (e.g., transformer nameplate data, H2, CH4, etc.).
(c) Training the machine learning algorithm with the "labeled data" - for example the classification "good" or "bad". or a classification comprising three or more classes.
(d) The machine learning algorithm "learns" the relationship between the attributes (or features) and the outcome. After the training, the machine learning algorithm can make predictions on new data for which there is no outcome, i.e., no class imposed by humans.

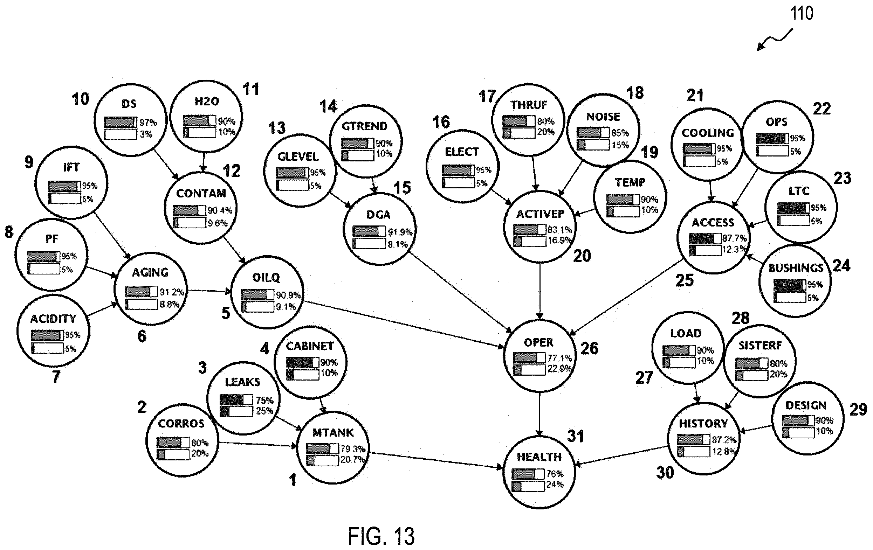

For illustration rather than limitation, Fig. 13 illustrates a Bayesian Network which is exemplary for Classification and Regression Trees (CART). Each node of the Bayesian Network represents a transformer major component or operational data plus essential test results such as dissolved gas analysis (DGA), electrical tests, etc., showing monitors with belief in that particular node or functionality given no evidence and based on prior probabilities (prior knowledge). This is called "instantiation" of the Bayesian Network. By setting the parameter values at the nodes of the Bayesian Network, the effect on the power transformer health is determined by probabilistic propagation through the Bayesian Network.

In the exemplary CART of Fig. 13, the following nodes are included (the node numbers referring to the numbers shown in Fig. 13):
Node 1: Main tank
Node 2: Corrosion
Node 3: Leaks
Node 4: Main cabinet
Node 5: Oil quality
Node 6: Oil aging
Node 7: Acidity
Node 8: Power factor
Node 9: Interfacial tension
Node 10: Dielectric susceptibility
Node 11: Moisture
Node 12: Contaminants
Node 13: Gas level
Node 14: Gas trend
Node 15: Dissolved Gas Analysis (DGA)
Node 16: Electrical tests
Node 17: Thru Fault
Node 18: Noise Level
Node 19: Winding temperature
Node 20: Active part
Node 21: Cooling system
Node 22: Oil preservation system
Node 23: Load tap changer
Node 24: Bushings
Node 25: Accessories
Node 26: Operational data
Node 27: Load
Node 28: Sister failures
Node 29: Design issues
Node 30: History
Node 31: Probability health

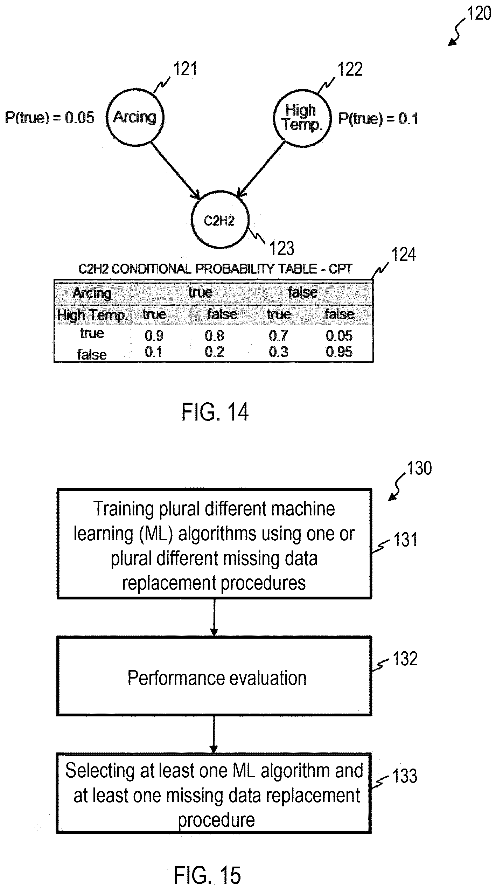

Fig. 14 illustrates some nodes 121-123 of a Bayesian Network relating to the probability of arcing (node 121), the probability of a high temperature condition (node 122), and the probability of C₂H₂ being dissolved in insulating oil (node 123). A conditional probability table 124 associated with the node 123 indicates the probability propagation from nodes 121, 122 to node 123. A change in the probability for one of nodes 121, 122 having the value "true" or "false", respectively, affects the probability for node 123 indicating that C₂H₂ is dissolved in insulating oil of the power transformer.

During training of a Bayesian network, the conditional probability values in the conditional probability tables of the Bayesian Network may be learned. The learning process (method 50 in Fig. 2 and Fig. 3) may take place while the algorithm creates internal selection criteria, so that when a new element is provided to the system for classification it will be classified in a correct way with a reliability that is determined by the quality of the machine learning algorithm and the training process.

### Selection of suitable machine learning algorithm and missing data replacement procedure

In order to provide a reliable and accurate condition classification by the automatic classification procedure of the condition classification device 30, training may be performed for one or several machine learning algorithms and/or one or several missing data replacement procedures.

Certain missing data replacement strategies may work better for some parameter than for others. Machine learning classification algorithms may be used to assess a power network asset condition after the machine learning classification algorithms have been properly trained using training data captured from real power network assets (such as plural power transformers with multiple operational data like nameplate, load, gas in oil, oil quality, bushing power factor and capacitance, load tap changer operations, type, gases, etc.). The best machine learning algorithm(s) (i.e., those that provide best accuracies in the classification process) can be tested against the same data but using a different missing data replacement procedure, until the optimum machine learning algorithm and data replacement procedure are found.

Fig. 15 is a flow chart of a method 130 of adapting an automatic classification procedure to training data associated with a plurality of power network assets (such as a plurality of power transformers, for example).

At step 131, plural different machine learning algorithms are trained using the training data. The training may include supervised learning. A missing data replacement procedure may be used to provide substitute values where parameter values are missing in a data set of the training data.

The plural different machine learning algorithms that are trained at step 131 may comprise at least one linear algorithm selected from a group consisting of general linear regression (GLM) and linear discriminant analysis (LDA). Alternatively or additionally, the plurality of different machine learning algorithms that is trained at step 131 may comprise at least one nonlinear algorithm selected from a group consisting of classification and regression trees (CART), a Naive Bayes algorithm (NB), Bayesian networks, K-nearest neighbor (KNN), and a support vector machine (SVM). Alternatively or additionally, the plurality of different machine learning algorithms that is trained at step 131 may comprise at least one ensemble algorithm selected from a group consisting of random forest, tree bagging, an extreme gradient boosting machine, and artificial neural networks.

At step 131, the machine learning algorithms may learn the statistical mapping between inputs (a set of parameter values) and output (a condition classification) through typically a large number of examples provided in the training phase (number of cases available in the training data), in which each example generally contains a large number of parameter values (for example transformer age, dissolved gas analysis history, load, etc.). Supervised learning may take place through a comparison between the output of each individual machine learning algorithm and the condition classification given by a human expert. An error function can be defined and a statistical process can be employed to minimize the error function so that each algorithm will provide the best possible accuracy based on its implementation.

At step 132, a performance evaluation may be performed. The performance evaluation is preferably performed based on test data that is not included in the training data. The performance evaluation may comprise testing the condition classification output by the trained machine learning algorithms and comparing the results against the classification provided by a human expert.

At step 133, at least one of the machine learning algorithms and, optionally, at least one of plural missing data replacement procedures used at step 131 is selected for use in the condition classification device 30. The selecting step 133 may comprise selecting the machine learning algorithm and missing data replacement procedure that, in the performance evaluation, had a maximum number of condition classifications that matched those of the human expert.

Alternative or additional criteria may be employed for selecting a machine learning algorithm and/or a missing data replacement procedure from a plurality of candidates. For illustration, the socalled confusion matrix may be evaluated that compares the results given by the trained machine learning algorithm to those given by the human expert. The selecting step 133 may comprise selecting the machine learning algorithm and missing data replacement procedure that had a maximum number of condition classifications that matched those of the human expert, but which did not incorrectly classify any power network asset that required attention as being in a normal operation state and/or that had the lowest number of incorrect classifications in which a power network asset that required attention was classified as being in a normal operation state.

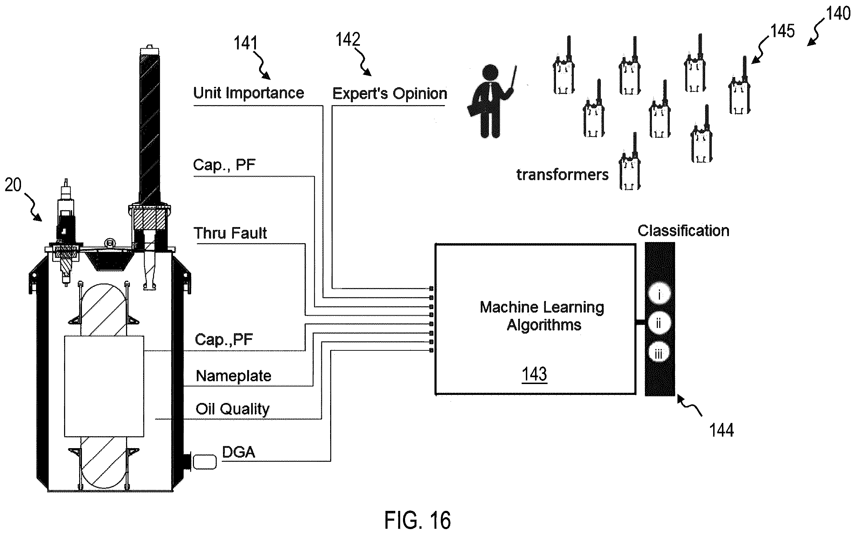

Fig. 16 is a schematic diagram illustrating the adaptation of an automatic classification procedure for use in a condition classification of a power network asset. A plurality of machine learning algorithms 143 respectively receive parameter values 141 associated with a power network asset 20. The parameter values 141 may include an importance rating, a capacitance and power factor of a bushing, a ThruFault, a capacitance and power factor of a winding, information taken from the nameplate, information on oil quality, and information on results of a dissolved gas analysis (DGA). The machine learning algorithms 143 are trained. Supervised learning may be performed that uses an expert opinion 142. The expert opinion 142 may provide a classification for a plurality of power network assets 145, which may be a plurality of transformers. The machine learning algorithms 143 are trained in such a way that the condition classification 144 provided by the machine learning algorithms 143 typically matches that provided by the human expert. By selecting at least one of the best-performing machine learning algorithm and/or at least one of the best performing data replacement procedures from plural machine learning algorithms and plural data replacement procedures, an automatic classification procedure for condition classification is obtained that performs well even when operating on new data on which it has not been previously trained.

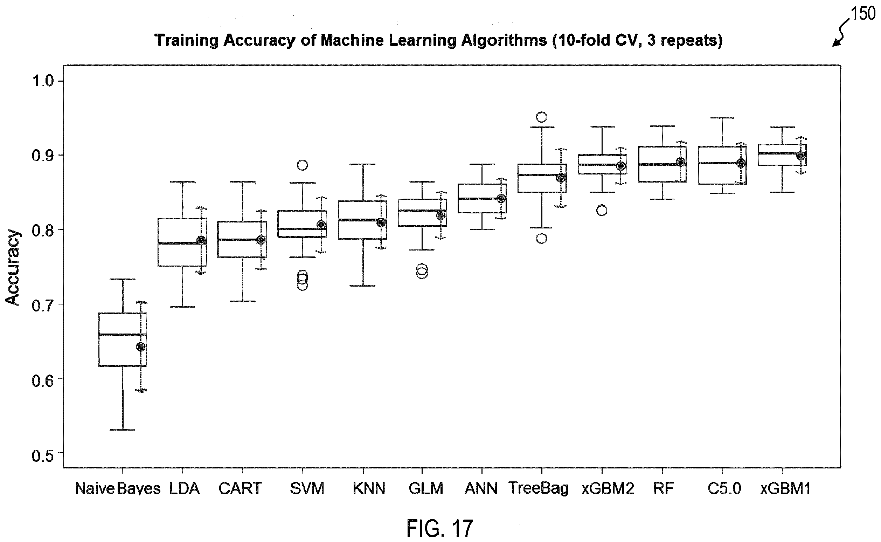

Fig. 17 is a graph showing the performance evaluation of a plurality of machine learning algorithms trained with training data including 800 data sets. The training accuracy shown in Fig. 17 is obtained by comparing the classification of the whole training set to the classification provided by human experts. The training accuracy shown in Fig. 17 has been obtained by ten-fold cross validation (CV) and three repeats. The ML algorithms are Naive Bayes, Linear Discriminant Analysis (LDA), Classification and Regression Trees (CART), General Linear Model (GLM), Support Vector Machine (SVM), K-Nearest Neighbor (KNN), Artificial Neural Networks (ANN), Tree Bagging, Extreme Gradient Boosting Machine (xGBM1 and xGBM2), Random Forest (RF) and C5.0. The upper and lower boundaries of the boxes and the solid horizontal line positioned within each box in Fig. 17 represent the Q3 and Q1 values and the median, respectively. The solid lines illustrate the upper and lower ranges. The solid circles illustrate the mean value. The dotted lines represent the range of +/- 1 standard deviation. The empty circles show upper and lower outliers, where present.

For the exemplary training data used in Fig. 17, the top five best performing models are all variations and ensembles of Classification and Regression Trees (CART). Their major differences are in the process of building the multiple trees that will best separate the data after learning from the training dataset.

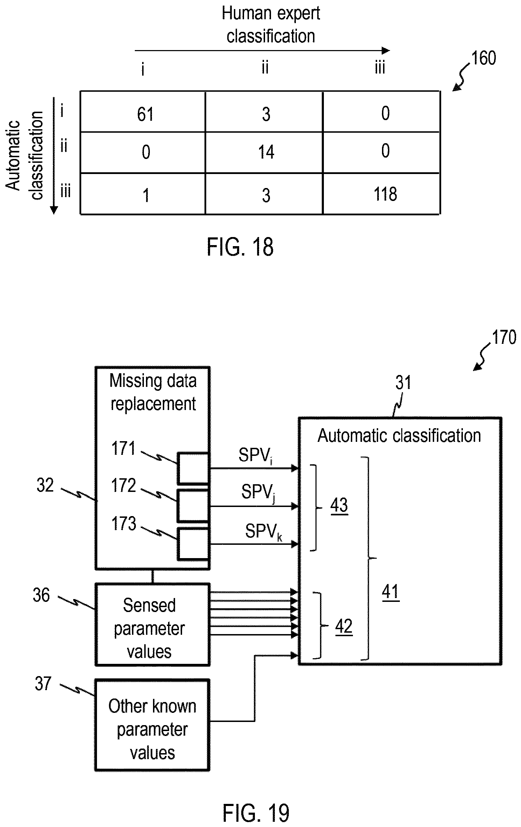

Fig. 18 is a table showing the confusion matrix for the best-performing machine learning algorithm, Extreme Gradient Boosting Machine 1 (xGBM1), of Fig. 17. The confusion matrix is obtained by comparing the output of the automatic classification procedure with missing data replacement when classifying data that was not used during training (200 new cases not used during training) against the human experts' opinion for those new cases. The following classes are used in the present example:
- a first class (i) indicating that a power network asset operates normally;
- a second class (ii) indicating that a power network asset requires some attention; and
- a third class (iii) indicating that a power network asset requires immediate attention.

The Machine Learning algorithms showed an impressive accuracy when analyzing complex power transformer data, even without the use of any engineering model. In other words the algorithms do not need to be provided with reference levels or flags to indicate that a given parameter was within acceptable range or outside "normal" levels. The twelve machine learning models were only provided with the final classification between the above-mentioned classes (i), (ii), (iii) previously established by transformer human experts.

The best performing algorithm (xGBM1) presented near 97% accuracy when analyzing the 200 new test cases unseen during training. It missed one class (i) case that was "wrongly" but conservatively classified as class (iii), three class (ii) cases that were wrongly classified as class (i) and three class (ii) cases that were wrongly classified class (iii). No class (iii) case was wrongly classified. The significant number of misses in practical terms is three class (ii) cases classified as class (i) cases (i.e., classified as normal power transformers although the human expert considered those power transformers to require some attention) out of 200 total, leading to 3/200 = 1.5% real miss since the other misses were conservative and would not lead to any unfavorable situation like a possible failure.

### Using an automatic classification procedure and missing data replacement procedure for automatic online or offline condition classification by a condition classification device

The results of the adaptation of the automatic classification procedure (which may involve training plural machine learning algorithms using one or several different data replacement procedures) may be used for performing condition classification of a power transformer or of another power network asset. For illustration, the automatic classification procedure executed by the automatic classification module 31 may depend on which one of several trained machine learning techniques showed the best performance. Additional information obtained in the adaptation of the automatic classification procedure for power network asset condition classification may be used by the condition classification device.

Fig. 19 is a block diagram representation of a condition classification device 170 according to an embodiment. The condition classification device 170 may include an automatic classification module 31 and a missing data replacement module 32 that are generally operative as explained above. However, the condition classification device 170 may harness additional information that has been determined during training the machine learning algorithm(s) performed by the automatic classification module 31. For illustration, the missing data replacement module 32 may be operative to perform several different missing data replacement procedures 171, 172, 173. Different missing data replacement procedures 171, 172, 173 may be performed to generate different substitute values SPVᵢ, SPVⱼ, and SPVₖ for different missing parameter values.

The different missing data replacement procedures 171, 172, 173 may respectively be selected from a group consisting of
- using a default value;
- using a mean or median value of a statistical distribution;
- using a random value determined in accordance with a statistical distribution;
- hard value imputation;
- using a value determined based on parameter correlations,
which have been explained in detail above. At least one of the missing data replacement procedures 171, 172, 173 may be a single value imputation (e.g., using a default value, educated guess, or using a mean or median value). At least one other missing data replacement procedure 171, 172, 173 may be a more complex procedure and may use, e.g., feature correlation, multiple imputation, or use of probabilistic believe propagation.

Which one of the missing data replacement procedures 171, 172, 173 is invoked for a given parameter may depend on the performance of the different missing data replacement procedures 171, 172, 173 and/or on which other parameters are available. For illustration, feature correlation may exhibit good performance for some parameter values, but may not be a viable option if several highly correlated parameter values are not available for a power network asset, with these highly correlated parameter values having little or no correlation with those parameter values that are available for the power network asset.

Additionally or alternatively, the methods and condition classification devices according to embodiments may be operative to provide information on the expected accuracy of a condition classification, in dependence on which parameter values are not available for a given power network asset. The expected accuracy, or confidence level, may be output via a user interface or a network interface.

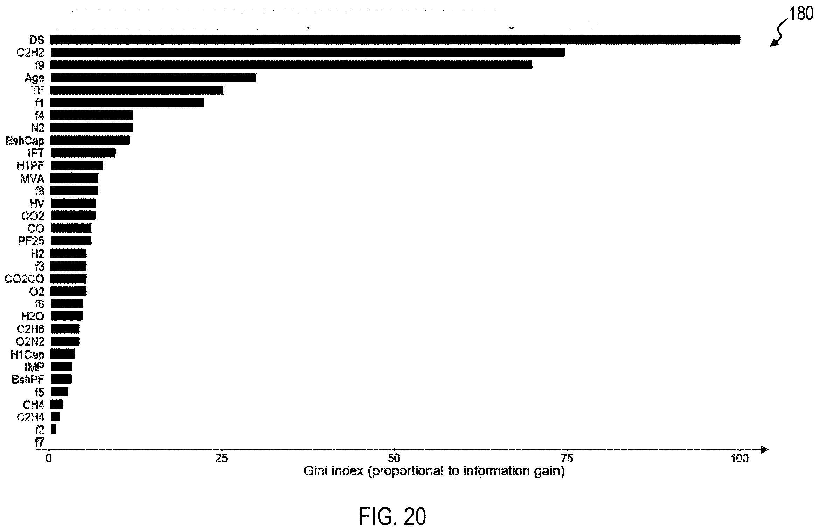

Fig. 20 illustrates a graph 180 representing information gain (measured by the Gini index) resulting when different parameter values are not available and must be substituted using a missing data replacement procedure. In the exemplary data of graph 180, the Gini index is large when substitute values are used for the dielectric strength (DS) or the C₂H₂ dissolved gas in oil concentration (C₂H₂). This corresponds to a large information gain, which indicates that the missing data replacement procedure adds information, which reduces the accuracy or confidence level. The Gini index is small when substitute values are used for the CH₄ and C₂H₄ dissolved gas in oil concentrations (CH₄ and C₂H₄). This corresponds to a small information gain, which indicates that the missing data replacement procedure adds only little information, which reflects a high accuracy or confidence level.

### De-centralized condition classification system

Results of a condition classification performed by the condition classification device 30 may be output locally at a user interface 35 of the condition classification device 30, as has been explained above. The techniques disclosed herein may also be used in systems that involve plural spatially separated computing device that communicate with each other via a wide area network or the internet 37.

Fig. 21 shows a schematic block diagram representation of a power network 10 with a condition classification device 30. The condition classification device 30 may be implemented by a server, cloud computers, or another computing facility. Terminal devices 38, 39, which may be portable or stationary computers or other mobile communication devices (such as tablets or smart phones) allow engineers to communicate with the condition classification device 30 via the wide area network or internet 37. Information on the condition classification, which involves the combination of an automatic classification procedure and a missing data replacement procedure, may be communicated to the terminal devices 38, 39 via the wide area network or internet 37 for outputting.

### Use of the missing data replacement procedure for accommodatins changes in the automatic classification procedure

As has already been explained above, the need to generate substitute values for one or several parameter value(s) that are not available for a power network asset may have various reasons, including the absence of sensors for a parameter value required as input by the automatic classification procedure.

One exemplary scenario in which the missing data replacement procedure may be applied to generate a substitute value for the same parameter value for all, or at least a large fraction, of the power network assets that are being monitored is that the automatic classification procedure is enhanced, possibly long after installation of the power network assets, to use a new parameter value as input. For illustration, a new parameter value may be discovered to be of relevance to the condition classification, long after power transformers or other power network assets have been built and installed. It may not be possible to retrofit the installed power network assets with a sensor that would be capable of measuring this new parameter value. In this case, the missing data replacement procedure may be used to generate the substitute value for this new parameter value that has subsequently been incorporated into the inputs of the automatic classification procedure.

A suitable missing data replacement procedure for such a new parameter may be obtained by laboratory experiments or physical modeling, even when little empirical information may be available for the effect of the new parameter on the condition classification.

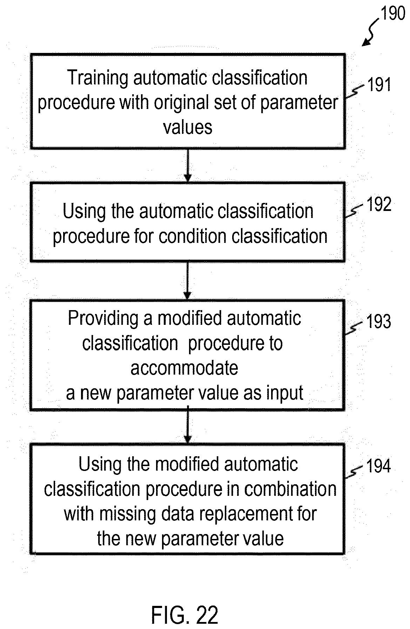

Fig. 22 is a flow chart of a method 190 according to an embodiment. At step 191, an automatic classification procedure is adapted for use in power network asset condition classification, as has been explained above. At step 192, the automatic classification procedure may be used in combination with a missing data replacement procedure to perform condition classification of power network assets. At step 193, the automatic classification procedure may be changed in such a way that it uses a new parameter value as input. The new parameter value may be measured in only few, or even none, of the power network assets for which condition classification is performed. The missing data replacement procedures that are applied to compensate for missing parameter values from a power network asset mitigate this problem. At step 194, the automatic classification procedure that requires the new parameter value as input is used in combination with a missing data replacement procedure that provides a substitute value for the new parameter value for some or even all of the power network assets. As has been explained herein, the use of suitable missing data replacement procedures allows high accuracy condition classification to be attained even when a substitute value must be used for a parameter value.

### Exemplary Effects and Further Modifications

The methods, devices, power networks, and computer-readable instruction code according to embodiments of the invention addresses the need for condition classification tools that can process a large number of inputs, while providing good classification results for a condition classification of a power network asset for which not all of the required parameter values are available. The methods, devices, power networks, and computer-readable instruction code according to embodiments also allow information to be provided on how a missing data replacement strategy affects the confidence level of the obtained condition classification result.

While exemplary embodiments have been explained with reference to the drawings, modifications and alterations may be implemented in other embodiments. The methods, devices, power networks, and computer-readable instruction code may be used for condition classification of power network assets other than power transformers. Machine learning models and/or missing data replacement procedures different from the ones discussed herein in detail may be used in further embodiments.

## Claims

1. A method for a power network (10), comprising:
performing, by an electronic device (30), an automatic classification procedure for a condition classification of a power network asset (11, 20, 25), wherein the automatic classification procedure is operative to assign the power network asset (11, 20, 25) to one of at least two different classes that comprise a class indicating that the power network asset (11, 20, 25) operates normally and a class indicating that the power network asset (11, 20, 25) requires attention,
wherein the automatic classification procedure performs the condition classification using a set of parameter values (41) as inputs,
wherein only a subset (42) of the set of parameter values (41) is available for the power network asset (11, 20, 25) and at least one parameter value of the set (41) is not available for the power network asset (11, 20, 25), wherein the subset of parameter values (42) that is available for the power network asset (11, 20, 25) includes parameter values provided by sensors (21, 22, 26, 27) installed on the power network asset (11, 20, 25);
performing, by the electronic device (30), a missing data replacement procedure to determine at least one substitute parameter value (43), wherein the missing data replacement procedure is selected from a group consisting of the following procedures:
- using a default value;
- using a mean or median value of a statistical distribution;
- using a random value determined in accordance with a statistical distribution;
- hard value imputation;
- using a value determined based on parameter multivariate correlations;
using the subset of parameter values (42) and the at least one substitute parameter value (43) in combination as inputs for the automatic classification procedure to obtain the condition classification of the power network asset (11, 20, 25).

2. The method of claim 1,
wherein the missing data replacement procedure is performed to determine a substitute value for a parameter value for which no online monitoring is performed during operation of the power network asset (11, 20, 25).

3. The method of claim 1 or claim 2,
wherein the missing data replacement procedure is performed to determine a substitute value for a parameter value that has been incorporated into the inputs of the automatic classification procedure after manufacture or installation of the power network asset (11, 20, 25).

4. The method of any one of the preceding claims,
wherein the missing data replacement procedure is performed to determine a substitute value for a parameter value that is independent of an operation condition of the power network asset (11, 20, 25).

5. The method of any one of the preceding claims,
wherein the missing data replacement procedure is performed to determine a substitute value for at least one of:
an age of the power network asset (11, 20, 25);
a voltage class of the power network asset (11, 20, 25);
a power of the power network asset (11, 20, 25);
an importance rating of the power network asset (11, 20, 25);
a ThruFault of the power network asset (11, 20, 25).

6. The method of any one of the preceding claims,
wherein the power network asset (11, 20, 25) comprises an insulation system, wherein the missing data replacement procedure is performed to determine a substitute value for at least one parameter relating to the insulation system; and/or
wherein the power network asset (11, 20, 25) comprises a winding, wherein the missing data replacement procedure is performed to determine a substitute value for at least one parameter of the winding; and/or
wherein the power network asset (11, 20, 25) comprises a bushing, wherein the missing data replacement procedure is performed to determine a substitute value for at least one parameter of the bushing; and/or
wherein the power network asset (11, 20, 25) comprises a cooling system, wherein the missing data replacement procedure is performed to determine a substitute value for at least one parameter of the cooling system; and/or
wherein the power network asset (20, 25) comprises a load tap changer, wherein the missing data replacement procedure is performed to determine a substitute value for at least one parameter of the load tap changer.

7. The method of any one of the preceding claims, further comprising:
determining confidence information indicative of an accuracy of the condition classification when the missing data replacement procedure is performed; and
outputting the confidence information.

8. The method of claim 7,
wherein the confidence information is determined in dependence on how many substitute values have been inputted to the automatic classification procedure and/or in dependence on which parameters are affected by the inputting of the substitute values,
optionally wherein the confidence information is determined based on a Gini index.

9. The method of any one of the preceding claims, further comprising:
selecting, by the electronic device, the missing data replacement procedure from a plurality of missing data replacement procedures.

10. The method of claim 9,
wherein at least two different missing data replacement procedures are performed for at least two different parameter values of the set that are not available for the power network asset (11, 20, 25).

11. The method of any one of the preceding claims,
wherein a first parameter value and a second parameter value from the set of parameter values (41) are not available for the power network asset (11, 20, 25),
a first missing data replacement procedure is performed to automatically determine a first substitute parameter value for the first parameter value, and
a second missing data replacement procedure is performed to automatically determine a second substitute parameter value for the second parameter value, the second missing data replacement procedure being different from the first missing data replacement procedure,
wherein an accuracy of the condition classification is increased by performing the second missing data replacement procedure to determine the second substitute parameter value, as compared to a case in which the first missing data replacement procedure is used to determine both the first substitute parameter value and the second substitute parameter value.

12. The method of any one of the preceding claims,
wherein the power network asset (11, 20, 25) is a transformer (20, 25) or a generator (11).

13. Machine-readable instruction code comprising instructions which, when executed by a processor of an electronic device, cause the electronic device to perform the method of any one of the preceding claims.

14. An electronic device (30), comprising:
an interface (33) configured
to receive data associated with a power network asset (11, 20, 25); and
a processing device (31, 32) configured to perform an automatic classification procedure for a condition classification of the power network asset (11, 20, 25), wherein the automatic classification procedure is operative to assign the power network asset (11, 20, 25) to one of at least two different classes that comprise a class indicating that the power network asset (11, 20, 25) operates normally and a class indicating that the power network asset (11, 20, 25) requires attention, wherein the automatic classification procedure is operative to use a set of parameter values (41) as inputs,
wherein only a subset (42) of the set of parameter values (41) is available for the power network asset and at least one parameter value of the set is not available for the power network asset, wherein the subset of parameter values (42) that is available for the power network asset (11, 20, 25) includes parameter values provided by sensors (21, 22, 26, 27) installed on the power network asset (11, 20, 25), and
the processing device is further configured to
perform a missing data replacement procedure to determine at least one substitute parameter value (43), wherein the missing data replacement procedure is selected from a group consisting of the following procedures:
- using a default value;
- using a mean or median value of a statistical distribution;
- using a random value determined in accordance with a statistical distribution;
- hard value imputation;
- using a value determined based on parameter multivariate correlations, and
use the subset of parameter values (42) and the at least one substitute parameter value (43) in combination as inputs for the automatic classification procedure to obtain the condition classification of the power network asset (11, 20, 25).

15. A power network (10), comprising:
a power network asset (11, 20, 25); and
the electronic device (30) of claim 14 to perform a condition classification of the power network asset.

## Patentansprüche

1. Verfahren für ein Energienetz (10), das Folgendes aufweist:
Durchführen einer automatischen Klassifizierungsprozedur für eine Zustandsklassifizierung eines Energienetzgegenstands (11, 20, 25) durch eine elektronische Vorrichtung (30), wobei die automatische Klassifizierungsprozedur in der Lage ist, den Energienetzgegenstand (11, 20, 25) einer von mindestens zwei verschiedenen Klassen zuzuweisen, die eine Klasse, die angibt, dass der Energienetzgegenstand (11, 20, 25) regulär arbeitet, und eine Klasse, die angibt, dass der Energienetzgegenstand (11, 20, 25) Aufmerksamkeit erfordert, aufweisen,
wobei die automatische Klassifizierungsprozedur die Zustandsklassifizierung unter Verwendung einer Gruppe (41) von Parameterwerten als Eingangsdaten durchführt,
wobei lediglich eine Untergruppe (42) der Gruppe (41) von Parameterwerten für den Energienetzgegenstand (11, 20, 25) verfügbar ist und mindestens ein Parameterwert der Gruppe (41) nicht für den Energienetzgegenstand (11, 20, 25) verfügbar ist, wobei die Untergruppe (42) von Parameterwerten, die für den Energienetzgegenstand (11, 20, 25) verfügbar sind, Parameterwerte enthält, die durch Sensoren (21, 22, 26, 27) bereitgestellt werden, die an dem Energienetzgegenstand (11, 20, 25) installiert sind;
Durchführen einer Prozedur zum Ersetzen von fehlenden Daten durch die elektronische Vorrichtung (30), um mindestens einen Ersatzparameterwert (43) zu bestimmen, wobei die Prozedur zum Ersetzen von fehlenden Daten aus einer Gruppe ausgewählt wird, die aus den folgenden Prozeduren besteht:
- Verwenden eines Standardwertes;
- Verwenden eines Mittelwertes oder eines Medianwertes einer statistischen Verteilung;
- Verwenden eines Zufallswertes, der gemäß einer statistischen Verteilung bestimmt wird;
- Festwertzuteilung;
- Verwenden eines Wertes, der auf der Grundlage mehrdimensionaler Parameterkorrelationen bestimmt wird;
Verwenden der Untergruppe (42) von Parameterwerten und des mindestens einen Ersatzparameterwertes (43) in Kombination als Eingangsdaten für die automatische Klassifizierungsprozedur, um die Zustandsklassifizierung des Energienetzgegenstands (11, 20, 25) zu erhalten.

2. Verfahren nach Anspruch 1,
wobei die Prozedur zum Ersetzen fehlender Daten durchgeführt wird, um einen Ersatzwert für einen Parameterwert zu bestimmen, für den während des Betriebs des Energienetzgegenstands (11, 20, 25) keine OnlineÜberwachung durchgeführt wird.

3. Verfahren nach Anspruch 1 oder Anspruch 2,
wobei die Prozedur zum Ersetzen fehlender Daten durchgeführt wird, um einen Ersatzwert für einen Parameterwert zu bestimmen, der nach der Herstellung oder Installation des Energienetzgegenstands (11, 20, 25) in die Eingangsdaten der automatischen Klassifizierungsprozedur aufgenommen worden ist.

4. Verfahren nach einem der vorhergehenden Ansprüche,
wobei die Prozedur zum Ersetzen fehlender Daten durchgeführt wird, um einen Ersatzwert für einen Parameterwert zu bestimmen, der von einem Betriebszustand des Energienetzgegenstands (11, 20, 25) unabhängig ist.

5. Verfahren nach einem der vorhergehenden Ansprüche,
wobei die Prozedur zum Ersetzen fehlender Daten durchgeführt wird, um einen Ersatzwert zu bestimmen für wenigstens einen der folgenden Werte:
ein Alter des Energienetzgegenstands (11, 20, 25);
eine Spannungsklasse des Energienetzgegenstands (11, 20, 25);
eine Leistung des Energienetzgegenstands (11, 20, 25) ;
eine Bewertung der Bedeutung des Energienetzgegenstands (11, 20, 25);
einen "ThruFault" des Energienetzgegenstands (11, 20, 25).

6. Verfahren nach einem der vorhergehenden Ansprüche,
wobei der Energienetzgegenstand (11, 20, 25) ein Isolationssystem aufweist, wobei die Prozedur zum Ersetzen fehlender Daten durchgeführt wird, um einen Ersatzwert für mindestens einen Parameter bezüglich des Isolationssystems zu bestimmen; und/oder
wobei der Energienetzgegenstand (11, 20, 25) eine Wicklung aufweist, wobei die Prozedur zum Ersetzen fehlender Daten durchgeführt wird, um einen Ersatzwert für mindestens einen Parameter der Wicklung zu bestimmen; und/oder
wobei der Energienetzgegenstand (11, 20, 25) eine Durchführung aufweist, wobei die Prozedur zum Ersetzen fehlender Daten durchgeführt wird, um einen Ersatzwert für mindestens einen Parameter der Durchführung zu bestimmen; und/oder
wobei der Energienetzgegenstand (11, 20, 25) ein Kühlsystem aufweist, wobei die Prozedur zum Ersetzen fehlender Daten durchgeführt wird, um einen Ersatzwert für mindestens einen Parameter des Kühlsystems zu bestimmen; und/oder
wobei der Energienetzgegenstand (11, 20, 25) einen Lastabgriffwechsler aufweist, wobei die Prozedur zum Ersetzen fehlender Daten durchgeführt wird, um einen Ersatzwert für mindestens einen Parameter des Lastabgriffwechslers zu bestimmen.

7. Verfahren nach einem der vorhergehenden Ansprüche, das ferner Folgendes aufweist:
Bestimmen von Konfidenzinformationen, die eine Genauigkeit der Zustandsklassifizierung angeben, wenn die Prozedur zum Ersetzen fehlender Daten durchgeführt wird; und
Ausgeben der Konfidenzinformationen.

8. Verfahren nach Anspruch 7,
wobei die Konfidenzinformationen in Abhängigkeit davon, wie viele Ersatzwerte in die automatische Klassifizierungsprozedur eingegeben worden sind und/oder in Abhängigkeit davon, welche Parameter durch das Eingeben der Ersatzwerte beeinflusst werden, bestimmt werden,
wahlweise wobei die Konfidenzinformationen auf der Grundlage eines Gini-Index bestimmt werden.

9. Verfahren nach einem der vorhergehenden Ansprüche, das ferner Folgendes aufweist:
Auswählen der Prozedur zum Ersetzen fehlender Daten aus mehreren Prozeduren zum Ersetzen fehlender Daten durch die elektronische Vorrichtung.

10. Verfahren nach Anspruch 9,
wobei mindestens zwei verschiedene Prozeduren zum Ersetzen fehlender Daten für mindestens zwei verschiedene Parameterwerte aus der Gruppe, die für den Energienetzgegenstand (11, 20, 25) nicht verfügbar sind, durchgeführt werden.

11. Verfahren nach einem der vorhergehenden Ansprüche,
wobei ein erster Parameterwert und ein zweiter Parameterwert aus der Gruppe von Parameterwerten (41) für den Energienetzgegenstand (11, 20, 25) nicht verfügbar sind,
eine erste Prozedur zum Ersetzen fehlender Daten durchgeführt wird, um automatisch einen ersten Ersatzparameterwert für den ersten Parameterwert zu bestimmen, und
eine zweite Prozedur zum Ersetzen fehlender Daten durchgeführt wird, um automatisch einen zweiten Ersatzparameterwert für den zweiten Parameterwert zu bestimmen, wobei die zweite Prozedur zum Ersetzen fehlender Daten von der ersten Prozedur zum Ersetzen fehlender Daten verschieden ist,
wobei eine Genauigkeit der Zustandsklassifizierung durch das Durchführen der zweiten Prozedur zum Ersetzen fehlender Daten, um den zweiten Ersatzparameterwert zu bestimmen, verglichen mit einem Fall, in dem die erste Prozedur zum Ersetzen fehlender Daten verwendet wird, um sowohl den ersten Ersatzparameterwert als auch den zweiten Ersatzparameterwert zu bestimmen, erhöht wird.

12. Verfahren nach einem der vorhergehenden Ansprüche,
wobei der Energienetzgegenstand (11, 20, 25) ein Transformator (20, 25) oder ein Generator (11) ist.

13. Maschinenlesbarer Befehlscode, der Befehle aufweist, die bei Ausführung durch einen Prozessor einer elektronischen Vorrichtung bewirken, dass die elektronische Vorrichtung das Verfahren nach einem der vorhergehenden Ansprüche durchführt.

14. Elektronische Vorrichtung (30), die Folgendes aufweist:
eine Schnittstelle (33), die konfiguriert ist, Daten zu empfangen, die einem Energienetzgegenstand (11, 20, 25) zugeordnet sind; und
eine Verarbeitungsvorrichtung (31, 32), die konfiguriert ist, eine automatische Klassifizierungsprozedur für eine Zustandsklassifizierung des Energienetzgegenstands (11, 20, 25) durchzuführen, wobei die automatische Klassifizierungsprozedur in der Lage ist, den Energienetzgegenstand (11, 20, 25) einer von mindestens zwei verschiedenen Klassen zuzuweisen, die eine Klasse, die angibt, dass der Energienetzgegenstand (11, 20, 25) regulär arbeitet, und eine Klasse, die angibt, dass der Energienetzgegenstand (11, 20, 25) Aufmerksamkeit erfordert, aufweisen, wobei die automatische Klassifizierungsprozedur in der Lage ist, eine Gruppe (41) von Parameterwerten als Eingangsdaten zu verwenden,
wobei lediglich eine Untergruppe (42) der Gruppe (41) von Parameterwerten für den Energienetzgegenstand verfügbar ist und mindestens ein Parameterwert der Gruppe nicht für den Energienetzgegenstand verfügbar ist, wobei die Untergruppe (42) von Parameterwerten, die für den Energienetzgegenstand (11, 20, 25) verfügbar sind, Parameterwerte enthält, die durch Sensoren (21, 22, 26, 27) bereitgestellt werden, die an dem Energienetzgegenstand (11, 20, 25) installiert sind, und
wobei die Verarbeitungsvorrichtung ferner konfiguriert ist zum:
Durchführen einer Prozedur zum Ersetzen von fehlenden Daten, um mindestens einen Ersatzparameterwert (43) zu bestimmen, wobei die Prozedur zum Ersetzen von fehlenden Daten aus einer Gruppe ausgewählt wird, die aus den folgenden Prozeduren besteht:
- Verwenden eines Standardwertes;
- Verwenden eines Mittelwertes oder eines Medianwertes einer statistischen Verteilung;
- Verwenden eines Zufallswertes, der gemäß einer statistischen Verteilung bestimmt wird;
- Festwertzuteilung;
- Verwenden eines Wertes, der auf der Grundlage mehrdimensionaler Parameterkorrelationen bestimmt wird; und
Verwenden der Untergruppe (42) von Parameterwerten und des mindestens einen Ersatzparameterwertes (43) in Kombination als Eingangsdaten für die automatische Klassifizierungsprozedur, um die Zustandsklassifizierung des Energienetzgegenstands (11, 20, 25) zu erhalten.

15. Energienetz (10), das Folgendes aufweist:
einen Energienetzgegenstand (11, 20, 25); und
die elektronische Vorrichtung (30) nach Anspruch 14, um eine Zustandsklassifizierung des Energienetzgegenstands durchzuführen.

## Revendications

1. Procédé destiné à un réseau d'électricité (10), comprenant :
l'exécution, par un dispositif électronique (30), d'une procédure de classement automatique destinée au classement de l'état d'un actif de réseau d'électricité (11, 20, 25), la procédure de classement automatique fonctionnant pour assigner à l'actif de réseau d'électricité (11, 20, 25) l'une d'au moins deux classes différentes qui comprennent une classe indiquant que l'actif de réseau d'électricité (11, 20, 25) fonctionne normalement et une classe indiquant que l'actif de réseau d'électricité (11, 20, 25) requiert une certaine attention,
dans lequel la procédure de classement automatique effectue le classement d'état en utilisant un jeu de valeurs paramétriques (41) en entrée,
dans lequel seul un sous-ensemble (42) du jeu de valeurs paramétriques (41) est disponible pour l'actif de réseau d'électricité (11, 20, 25), et au moins une valeur paramétrique du jeu (41) n'est pas disponible pour l'actif de réseau d'électricité (11, 20, 25), le sous-ensemble de valeurs paramétriques (42) qui est disponible pour l'actif de réseau d'électricité (11, 20, 25) incluant des valeurs paramétriques fournies par des capteurs (21, 22, 26, 27) installés sur l'actif de réseau d'électricité (11, 20, 25),
l'exécution, par le dispositif électronique (30), d'une procédure de remplacement de données manquantes permettant de déterminer au moins une valeur substitutive de paramètre (43), la procédure de remplacement de données manquantes étant sélectionnée à partir d'un groupe constitué des procédures suivantes :
- l'utilisation d'une valeur par défaut,
- l'utilisation d'une valeur moyenne ou d'une valeur médiane d'une distribution statistique,
- l'utilisation d'une valeur aléatoire déterminée en fonction d'une distribution statistique,
- une imputation d'une valeur réelle,
- l'utilisation d'une valeur déterminée sur la base de corrélations à variables multiples de paramètres,
l'utilisation du sous-ensemble de valeurs paramétriques (42) et de la ou des valeurs substitutives de paramètres (43) en combinaison sous forme d'entrées de la procédure de classement automatique pour obtenir le classement d'état de l'actif de réseau d'électricité (11, 20, 25).

2. Procédé selon la revendication 1,
dans lequel la procédure de remplacement de données manquantes est réalisée pour déterminer une valeur substitutive pour une valeur paramétrique pour laquelle aucune surveillance en ligne n'est effectuée pendant le fonctionnement de l'actif de réseau d'électricité (11, 20, 25).

3. Procédé selon la revendication 1 ou la revendication 2,
dans lequel la procédure de remplacement de données manquantes est réalisée pour déterminer une valeur substitutive pour une valeur paramétrique qui a été incorporée dans les entrées de la procédure de classement automatique après la fabrication ou l'installation de l'actif de réseau d'électricité (11, 20, 25).

4. Procédé selon l'une quelconque des revendications précédentes,
dans lequel la procédure de remplacement de données manquantes est réalisée pour déterminer une valeur substitutive pour une valeur paramétrique qui est indépendante d'un état de fonctionnement de l'actif de réseau d'électricité (11, 20, 25).

5. Procédé selon l'une quelconque des revendications précédentes, dans lequel la procédure de remplacement de données manquantes est réalisée pour déterminer une valeur substitutive pour au moins un paramètre parmi :
l'âge de l'actif de réseau d'électricité (11, 20, 25),
la classe de tension de l'actif de réseau d'électricité (11, 20, 25),
la puissance de l'actif de réseau d'électricité (11, 20, 25),
une note d'importance de l'actif de réseau d'électricité (11, 20, 25),
un état « ThruFault » (défaut réel) de l'actif de réseau d'électricité (11, 20, 25).

6. Procédé selon l'une quelconque des revendications précédentes,
dans lequel l'actif de réseau d'électricité (11, 20, 25) comprend un système d'isolement, la procédure de remplacement de données manquantes étant réalisée pour déterminer une valeur substitutive pour au moins un paramètre se rapportant au système d'isolement, et/ou
dans lequel l'actif de réseau d'électricité (11, 20, 25) comprend un bobinage, la procédure de remplacement de données manquantes étant réalisée pour déterminer une valeur substitutive pour au moins un paramètre du bobinage, et/ou
dans lequel l'actif de réseau d'électricité (11, 20, 25) comprend une douille, la procédure de remplacement de données manquantes étant réalisée pour déterminer une valeur substitutive pour au moins un paramètre de la douille, et/ou
dans lequel l'actif de réseau d'électricité (11, 20, 25) comprend un système de refroidissement, la procédure de remplacement de données manquantes étant réalisée pour déterminer une valeur substitutive pour au moins un paramètre de système de refroidissement, et/ou
dans lequel l'actif de réseau d'électricité (11, 20, 25) comprend un changeur de prise de charge, la procédure de remplacement de données manquantes étant réalisée pour déterminer une valeur substitutive pour au moins un paramètre du changeur de prise de charge.

7. Procédé selon l'une quelconque des revendications précédentes, comprenant en outre :
la détermination d'informations de confiance indiquant la précision du classement d'état lorsque la procédure de remplacement de données manquantes est réalisée, et
la délivrance en sortie les informations de confiance.

8. Procédé selon la revendication 7,
dans lequel les informations de confiance sont déterminées en fonction du nombre de valeurs substitutives qui ont été appliquées en entrée de la procédure de classement automatique et/ou en fonction des paramètres qui sont affectés par la réception en entrée des valeurs substitutives,
en option dans lequel les informations de confiance sont déterminées sur la base d'un coefficient de Gini.

9. Procédé selon l'une quelconque des revendications précédentes, comprenant en outre :
la sélection, par le dispositif électronique, de la procédure de remplacement de données manquantes à partir d'une pluralité de procédures de remplacement de données manquantes.

10. Procédé selon la revendication 9,
dans lequel au moins deux procédures différentes de remplacement de données manquantes sont réalisées au moins de valeurs paramétriques différentes du jeu qui ne sont pas disponibles pour l'actif de réseau d'électricité (11, 20, 25).

11. Procédé selon l'une quelconque des revendications précédentes,
dans lequel une première valeur paramétrique et une seconde valeur paramétrique issues du jeu de valeurs paramétriques (41) ne sont pas disponibles pour l'actif de réseau d'électricité (11, 20, 25),
une première procédure de remplacement de données manquantes est réalisée afin de déterminer automatiquement une première valeur paramétrique substitutive pour la première valeur paramétrique, et
une seconde procédure de remplacement de données manquantes est réalisée afin de déterminer automatiquement une seconde valeur paramétrique substitutive pour la seconde valeur paramétrique, la seconde procédure de remplacement de données manquantes étant différente de la première procédure de remplacement de manquantes,
dans lequel la précision du classement d'état augmente en effectuant une seconde procédure de remplacement de données manquantes dans le but de déterminer la seconde valeur paramétrique substitutive par comparaison à un cas dans lequel la première procédure de remplacement de données manquantes est utilisée pour déterminer à la fois la première valeur paramétrique substitutive et la seconde valeur paramétrique substitutive.

12. Procédé selon l'une quelconque des revendications précédentes,
dans lequel l'actif de réseau d'électricité (11, 20, 25) est un transformateur (20, 25) ou bien un générateur (11) .

13. Code d'instructions pouvant être lues par une machine comprenant des instructions qui, lorsqu'elles sont exécutées par le processeur d'un dispositif électronique, amènent le dispositif électronique à réaliser le procédé conforme à l'une quelconque des revendications précédentes.

14. Dispositif électronique (30) comprenant :
une interface (33) configurée pour recevoir des données associées à un actif de réseau d'électricité (11, 20, 25), et
un dispositif de traitement (31, 32) configuré pour réaliser une procédure de classement automatique destinée au classement de l'état de l'actif de réseau d'électricité (11, 20, 25), la procédure de classement automatique fonctionnant pour assigner à l'actif de réseau d'électricité (11, 20, 25) l'une d'au moins deux classes différentes qui comprennent une classe indiquant que l'actif de réseau d'électricité (11, 20, 25) fonctionne normalement et une classe indiquant que l'actif de réseau d'électricité (11, 20, 25) requiert une certaine attention, où la procédure de classement automatique fonctionne pour utiliser un jeu de valeurs paramétriques (41) en entrée,
dans lequel seul un sous-ensemble (42) du jeu de valeurs paramétriques (41) est disponible pour l'actif de réseau d'électricité et au moins une valeur paramétrique du jeu n'est pas disponible pour l'actif de réseau d'électricité, le sous-ensemble de valeurs paramétriques (42) qui est disponible pour l'actif de réseau d'électricité (11, 20, 25) incluant des valeurs paramétriques fournies par des capteurs (21, 22, 26, 27) installés sur l'actif de réseau d'électricité (11, 20, 25), et
le dispositif de traitement est en outre configuré pour :
exécuter une procédure de remplacement de données manquantes permettant de déterminer au moins une valeur substitutive de paramètre (43), la procédure de remplacement de données manquantes étant sélectionnée à partir d'un groupe constitué des procédures suivantes :
- l'utilisation d'une valeur par défaut,
- l'utilisation d'une valeur moyenne ou d'une valeur médiane d'une distribution statistique,
- l'utilisation d'une valeur aléatoire déterminée en fonction d'une distribution statistique,
- une imputation d'une valeur réelle,
- l'utilisation d'une valeur déterminée sur la base de corrélations à variables multiples de paramètres, et
l'utilisation du sous-ensemble de valeurs paramétriques (42) et de la ou des valeurs substitutives de paramètres (43) en combinaison sous forme d'entrées de la procédure de classement automatique pour obtenir le classement d'état de l'actif de réseau d'électricité (11, 20, 25).

15. Réseau d'électricité (10) comprenant :
un actif de réseau d'électricité (11, 20, 25), et
le dispositif électronique (30) de la revendication 14 destinée à effectuer un classement d'état de l'actif de réseau d'électricité.
